# EUROPEAN PATENT APPLICATION

(11) **EP 2 818 493 A1**
(43) Date of publication of application: **31.12.2014**
(21) Application number: 13173565.6
(22) Date of filing: 25.06.2013
(51) Int. Cl.: C08G 61/12, H01L 51/00, H01L 51/05, H01L 51/42

(54) **Near infrared absorbing polymers for electronic applications**

(71) Applicant: BASF SE, 67056 Ludwigshafen (DE)
(72) Inventor: Flores, Jean-Charles, Dr., 68100 Mulhouse (FR); Welker, Matthias, 68300 St. Louis (FR); Chebotareva, Natalia, 68220 Hagenthal le Bas (FR); Turbiez, Mathieu G. R., Dr., 68170 Rixheim (FR)

(57) **Abstract**

The present invention relates to polymers comprising repeating units of the formula 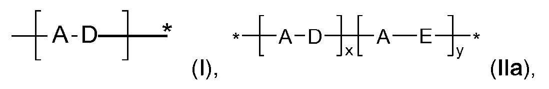 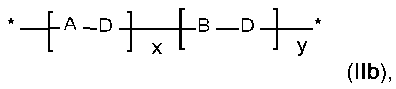 or 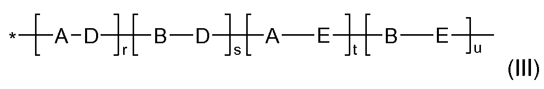 and their use as organic semiconductor material in organic electronic devices, especially in organic photovoltaics (solar cells) and photodiodes, or in a device containing a diode and/or an organic field effect transistor. The polymers according to the present invention show high absorption in the wavelength range above 1000 nm. A particularity of the polymers is their relatively high lying LUMO associated with a very low band gap, which allows them to provide high short-circuit current (Jsc) when used as photoactive material in combination with commercial C₆₀ / C₇₀ fullerene derivatives in solar cells or photodiodes.

## Description

The present invention relates to polymers comprising repeating units of the formula (I), **(IIa)** and **(IIb),** or (III) and their use as organic semiconductor material in organic electronic devices, especially in organic photovoltaics (solar cells) and photodiodes, or in a device containing a diode and/or an organic field effect transistor. The polymers according to the present invention show high absorption of in the wavelength range above 1000 nm.

The polymers according to this invention also show excellent solubility in organic solvents and excellent film-forming properties and stability, and can be used in solution-processed electronic devices such as organic photovoltaics (solar cells), photodiodes and organic field effect transistors.

B. Tieke et al., Macromol. Rapid Commun. 30 (2009) 1834-1840 disclose pyrrolo[3,4-c]pyrrole-1,4-dione carrying 3,4-ethylenedioxy-thiophenyl-phenyl (EDOT-phenyl) substituent groups. The following compounds are explicitly disclosed: 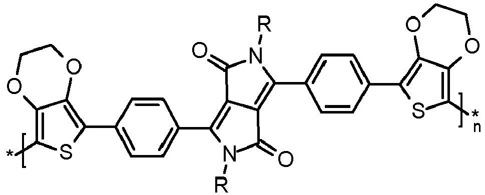 and 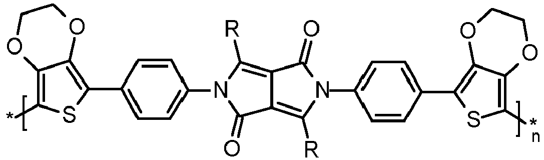 (R is 2-hexyldecyl or 4-t-butylphenyl). Those polymers exhibit band gaps >1.35 eV and UV/Visₘₐₓ < 650 nm. Indeed, absorption of high wavelength is limited by the phenyl-thiophene interaction, which limits the conjugation of the polymers.

B. Tieke et al., Macromol. Chem. Phys. 210 (2009) 431-439 disclose the synthesis and electropolymerization of bis(3,4-ethylenedioxythiophene)-substitued 1,4-diketo-3,6-diphenyl-pyrrolo[3,4-c]pyrrole. The following compounds are disclosed: 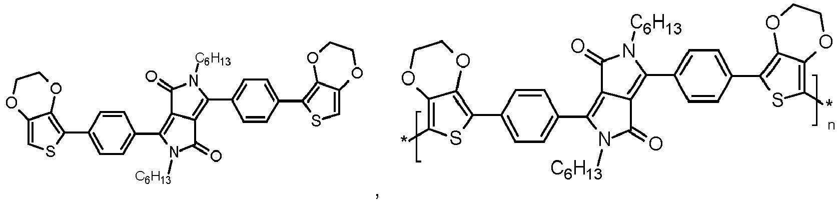 and

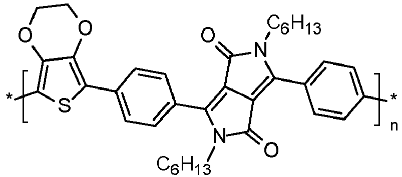

B. Tieke et al., Polymer 51 (2010) 6107-6114 disclose cross-linked polymers based on 2,3,5,6-tetra-substituted pyrrolo[3,4-c]pyrrole-1,4(2H, 5H)-diones, and carrying thienyl, 3,4-ethylenedioxy-thienyl- and 3,4-ethylenedithiathienyl- substituent groups. The following monomers are explicitly disclosed, as well as their respective polymers obtained by electropolymerization. Optical band gaps of the obtained polymers are >1.70 eV, as it is known that the interaction between the thiophene-DPP and the EDOT and EDST unit induces a torsion which limits the conjugation of the compounds and does not allow the compounds to absorb at a wavelength above 700 nm.

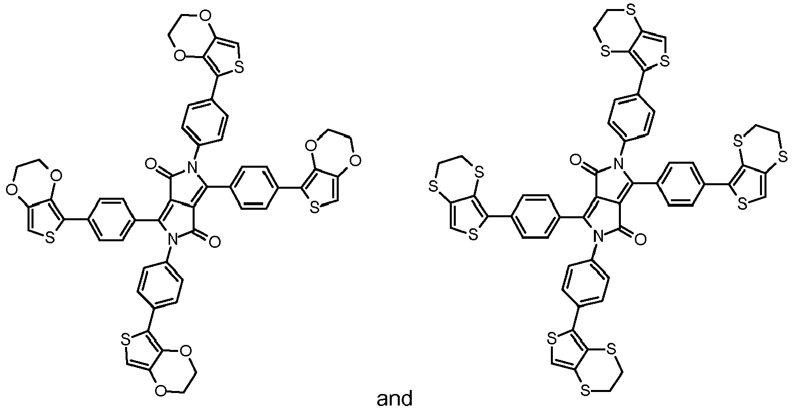

WO2004/090046 relates to fluorescent diketopyrrolopyrroles of formula 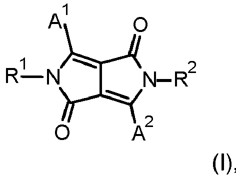 in which A¹ and A² can among others be a group of formula 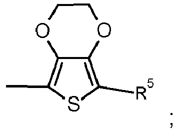 as well as to the process for their preparation and their use for the preparation of inks, colorants, pigmented plastics for coatings, non-impact-printing material, color filters, cosmetics, polymeric ink particle, toners, as fluorescent tracers, in color changing media, in solid dye lasers and electroluminescent devices. The following compounds are especially mentioned:

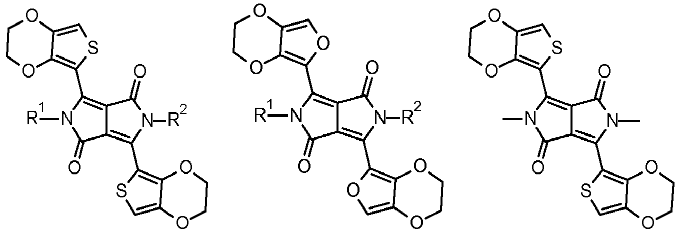

S.P. Mishra et al., Synthetic Metals 160 (2010) 2422-2429 describe the synthesis and characterization of soluble narrow band gap conducting polymers based on diketopyrrolopyrrole and propylenedioxythiophenes, such as, for example,

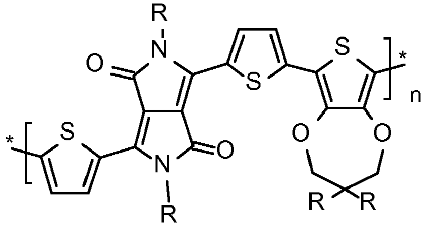

Those polymers show near IR absorption limited to wavelengths < 900 nm. Those structures are structurally different from those disclosed in the present invention due to the presence of propylenedioxythiophenes (Pro-DOT). Pro-DOT repeating units lead to a relatively twisted structure.

WO2012041849 relates to semiconductors based on diketopyrrolopyrroles compounds of formula 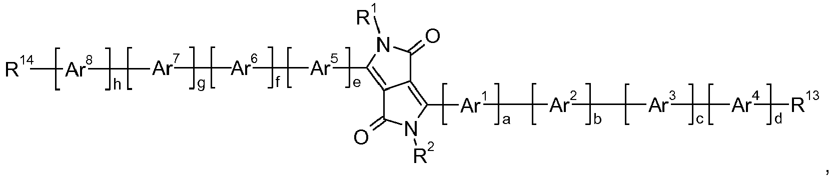 wherein a is 1, 2 or 3 and e is 1, 2 or 3, b, c, d, f, g and h are independently of each other 0, 1, 2 or 3. Ar¹ and Ar⁵ may represent groups of formula 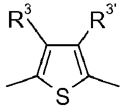 **(Xm),** 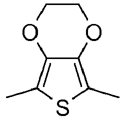 **(Xe'),** or 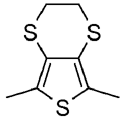 **(Xf').** Ar³, Ar⁴, Ar⁵, Ar⁶, Ar⁷ andAr⁸ may have the meaning of Ar¹. No compounds are explicitly disclosed comprising units **Xe',** orXf.

D. Cortizo-Lacalle et al., Journal of Materials Chemistry 22 (2012) 11310-11315 disclose an air stable, solution processable DPP-terthiophene copolymer of formula 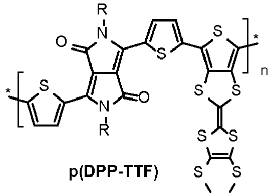 for the production of organic field effect transistors.

WO2010136352 relates to a method for polymerizing (hetero)aromatic compounds under formation of aryl-aryl carbon-carbon coupling to form conjugated polymers involving polymerizing in presence of catalyst/ligand system of palladium catalyst/tri-substituted phosphine. As examples of monomers, which can be used in the production of the polymers, among others compounds of formula 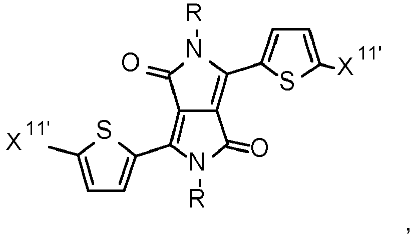 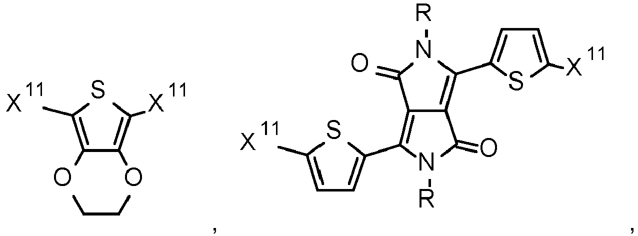 and 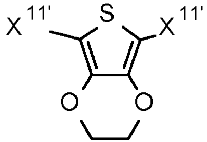 are mentioned. X¹¹ may be, for example, B(OH)₂, B(OH)₃-, BF₃-, or B(OR)₂ and X^{11'} may be, for example, halogen. No examples of polymers which comprise the above building blocks are disclosed.

WO2010115767 relates to pyrrolopyrrole derivatives useful in an organic semiconductor material, diode, a photodiode, a sensor, transistor and solar cell of formula 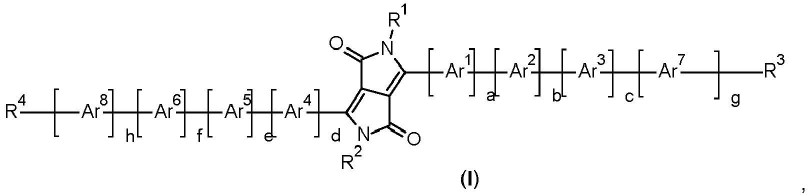 where a is 1, 2 or 3 and d is 0, 1, 2 or 3, b, c, e, f, g and h are independently of each other
0, 1, 2 or 3. Ar¹ and Ar⁴ may represent units of formula 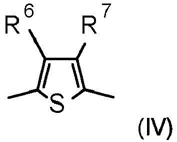 Ar³, Ar⁴, Ar⁵,
Ar⁶, Ar⁷ and Ar⁸ may have the meaning of Ar¹. R³ and R⁴ may be hydrogen or groups of formula

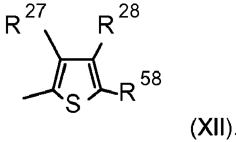

R⁶ and R⁷ are independently of each other hydrogen, C₁-C₂₅alkyl, C₁-C₁₈alkoxy, C₆-C₂₄aryl, C₇-C₂₅aralkyl, heteroaryl, or R⁶ and R⁷ together represent alkylene or alkenylene group which may be bonded via oxygen or sulphur to the thienyl residue and which may both have up to 25 carbon atoms.

R²⁷ and R²⁸ are independently of each other hydrogen, C₁-C₂₅alkyl, C₁-C₁₈alkoxy, C₆-C₂₄aryl, C₇-C₂₅ aralkyl, heteroaryl, or a R²⁷ and R²⁸ together or R²⁷ and R⁵⁸ together represent alkylene or alkenylene which may be both bonded via oxygen and/or sulfur to the thienyl residue and which may both have up to 25 carbon atoms.

R⁵⁸ represent alkylene or alkenylene group which may be bonded via oxygen or sulphur to the thienyl residue and which may both have up to 25 carbon atoms.

No examples of polymers are disclosed, where R⁶ and R⁷, or R²⁷ and R²⁸ are alkylene or alkenylene groups bonded via oxygen or sulphur to the thienyl residue.

WO2009047104 relates to pyrrolopyrrole derivatives of formula 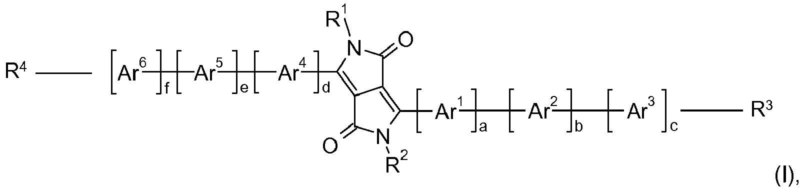 their use as organic semiconductor in organic devices, like diodes, organic field effect transistors and/or a solar cells, and their manufacture.
a and d independently of each other are 0, 1, 2 or 3, b, c, e, f, g and h are independently of each other 0, 1, 2 or 3. Ar¹ and Ar⁴ may be a group of formula 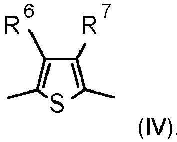 Ar², Ar³, Ar⁵ and Ar⁶ may also be a group of formula (IV). R³ and R⁴ may be hydrogen or a group of formula

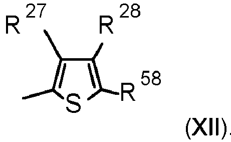

R⁶ and R⁷ are independently of each other hydrogen, C₁-C₂₅alkyl, C₁-C₁₈alkoxy, C₆-C₂₄aryl, C₇-C₂₅ aralkyl, heteroaryl, or R⁶ and R⁷ together represent alkylene or alkenylene group which may be bonded via oxygen or sulphur to the thienyl residue and which may both have up to 25 carbon atoms.

R²⁷ and R²⁸ are independently of each other hydrogen, C₁-C₂₅alkyl, C₁-C₁₈alkoxy, C₆-C₂₄aryl, C₇-C₂₅ aralkyl, heteroaryl, or a R²⁷ and R²⁸ together or R²⁷ and R⁵⁸ together represent alkylene or alkenylene which may be both bonded via oxygen and/or sulfur to the thienyl residue and which may both have up to 25 carbon atoms.

R⁵⁸ represent alkylene or alkenylene group which may be bonded via oxygen or sulphur to the thienyl residue and which may both have up to 25 carbon atoms.

No examples of compounds are disclosed, where R⁶ and R⁷, or R²⁷ and R²⁸ are alkylene or alkenylene groups bonded via oxygen or sulphur to the thienyl residue.

WO2008000664 relates to diketopyrrolopyrrole polymers of formula 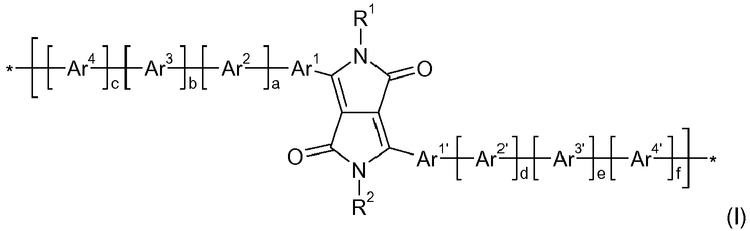 and their use
as organic semiconductors. a, b, c, d, e and f are 0 to 200. Ar¹, Ar^{1'}, Ar², Ar^{2'}, Ar³, Ar^{3'}, Ar⁴
and Ar^{4'} may be independently of each other a group of formula 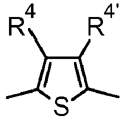 R⁴ and R^{4'}
may be hydrogen, C₁-C₂₅alkyl, which may optionally be substituted by E and/or interrupted by D, C₆-C₂₄aryl, which may optionally be substituted by G, C₂-C₂₀heteroaryl, which may optionally be substituted by G, C₁-C₁₈alkoxy, which may optionally be substituted by E and/or interrupted by D, C₇-C₂₅aralkyl , wherein aryl of aralkyl may be optionally substituted be G, or -CO-R²⁸, or R⁴ and R^{4'} form a ring.

To achieve efficient multiple junction solar cells (especially triple junction organic solar cells), and efficient photodiodes, there is still a need for new polymers capable of efficiently absorbing light of wavelengths above 1000 nm and showing high short circuit current values (Jsc) when used in solar cells or photodiodes, for example, in combination with commercial C₆₀ / C₇₀ fullerene derivatives. Additionally, those polymers need to show good solubility in organic solvents, good processability, good stability and film-forming properties.

It is one object of the present invention to provide polymers able to efficiently absorb near IR light of wavelength > 1000 nm, and show high short circuit current (Jsc), good processability and/or good stability when used in organic photovoltaics (solar cells), photodiodes and organic field effect transistors.

Indeed, this specific behaviour was achieved by polymers of the present invention, comprising repeating units of the formula (I), (IIa) and (IIb), or (III). A particularity of those polymers is their relatively high lying LUMO associated with a very low band gap, which allows efficient charge transfer and provides high short-circuit current (Jsc) when used as photoactive material in combination with commercial C₆₀ / C₇₀ fullerene derivatives in solar cells or photodiodes. The band gap can be controlled by varying the HOMO level through modifications of the electron donor repeating units, without significantly changing the LUMO level. As a consequence of this tuning, the voltages of these devices are lower than the one observed for materials typically developed for single junction solar cells (typically 0.2 to 0.5V compared to 0.6 to 1V for conventional materials). This is of great interest for application in photodiodes where the voltage is not an issue (a good detection/current at a given wavelength or throughout the solar spectrum is the desired property) or for multiple junction solar cell where you want to capture part of the spectrum which is not accessible to the conventional materials.

Accordingly, the present invention relates to polymers, comprising repeating units of the formula 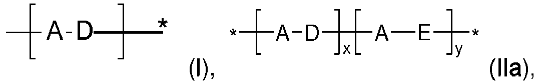 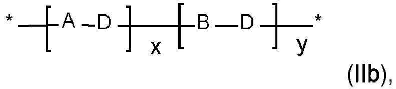 or 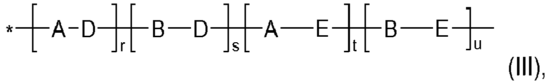 wherein
x = 0.01 to 0.99, y = 0.99 to 0.01, and wherein x + y = 1,
r+s=0.01 to 0.99, t+u=0.99 to 0.01, and wherein r+s+t+u=1,

A is a group of formula 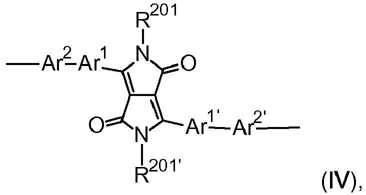 Ar¹, Ar^{1'}, Ar² and Ar^{2'} are independently of each other a group of formula 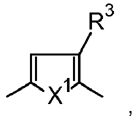 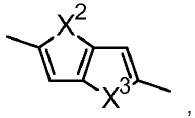 X¹ is O, S, or Se, especially S;
X² and X³ are independently of each other O, S, or Se, especially S;
R³ is H, C₁-C₂₅alkyl, C₃-C₁₂cycloalkyl, C₁-C₂₅alkoxy or C₁-C₂₅thioalkyl, C₂-C₂₅alkenyl, or C₂-C₂₅alkynyl,
R²⁰¹ and R^{201'} are independently of each other H, C₁-C₁₀₀alkyl, C₂-C₁₀₀alkenyl, or C₂-C₁₀₀alkynyl, -COOR¹⁰³, C₁-C₁₀₀alkyl which is substituted by one or more halogen atoms, hydroxyl groups, nitro groups, -CN, or C₆-C₁₈aryl groups and/or interrupted by -O-, -COO-, -OCO- or -S-; C₇-C₂₅arylalkyl, carbamoyl, C₅-C₁₂cycloalkyl, which can be substituted one to three times with C₁-C₁₀₀alkyl and/or C₁-C₁₀₀alkoxy; C₆-C₂₄aryl, in particular phenyl or 1- or 2 naphthyl which can be substituted one to three times with C₁-C₁₀₀alkyl, C₁-C₁₀₀thioalkoxy, and/or C₁-C₁₀₀alkoxy; and pentafluorophenyl;
R¹⁰³ is C₁-C₂₅alkyl, which may optionally be interrupted by one, or more oxygen, or sulphur atoms;
D is a group of formula 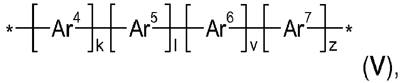 k is 0, or 1,
l is 1,
v is 0, or 1,
z is 0, or 1,
Ar⁴, Ar⁵, Ar⁶ and Ar⁷ are independently of each other a group of formula 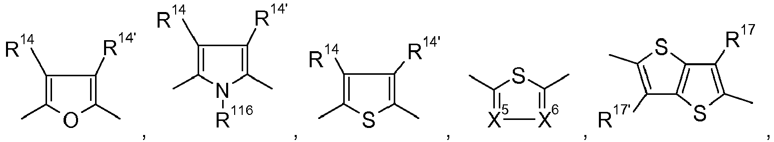 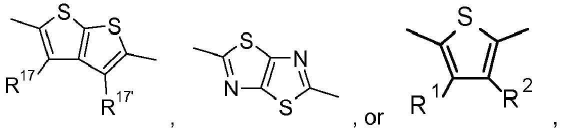 wherein one of X⁵ and X⁶ is N
and the other is CR¹⁴,
R¹⁴, R^{14'}, R¹⁷ and R^{17'} are independently of each other H, or a C₁-C₂₅alkyl group, which may optionally be interrupted by one or more oxygen atoms;
R¹¹⁶ is C₆-C₁₈aryl; C₆-C₁₈aryl which is substituted by C₁-C₁₈alkyl, or C₁-C₁₈alkoxy; or C₁-C₂₅alkyl, which may optionally be interrupted by one or more oxygen or sulphur atoms; or C₇-C₂₅arylalkyl; R¹ and R² are independently of each other C₁-C₂₅alkoxy, or C₁-C₂₅thioalkyl; or R¹ and R² form together a group 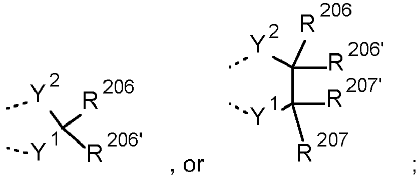 Y¹ and Y² are independently of each other O, or S;
R²⁰⁶, R^{206'}, R²⁰⁷ and R^{207'} are independently of each other H, C₁-C₁₈alkyl, C₁-C₁₈alkyl which is interrupted one, or more times by O; C₁-C₁₈alkoxy, C₁-C₁₈alkoxy which is interrupted
one, or more times by O; C₁-C₁₈fluoroalkyl, C₂-C₁₈alkenyl, C₂-C₁₈alkynyl, or CN; with the
proviso that at least one of Ar⁴, Ar⁵, Ar⁶ and Ar⁷ is a group of formula 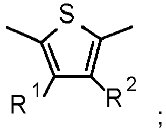 B is a group of formula IV, which is different from A, or B is a group of formula V, which is different from D;
E is a group of formula V, which is different from D, or E is a group of formula IV, which is different from A.

Advantageously, the polymer of the present invention, or an organic semiconductor material, layer or component, comprising the polymer of the present invention, can be used in organic photovoltaics (solar cells) and photodiodes, organic light emitting diodes (PLEDs, OLEDs), or in an organic field effect transistor (OFET).

The polymers of this invention preferably have a weight average molecular weight of 4,000 Daltons or greater, especially 4,000 to 2,000,000 Daltons, more preferably 10,000 to 1,000,000 and most preferably 10,000 to 100,000 Daltons. Molecular weights are determined according to high-temperature gel permeation chromatography (HT-GPC) using polystyrene standards. The polymers of this invention preferably have a polydispersity of 1.01 to 10, more preferably 1.1 to 3.0, most preferred 1.5 to 2.5. The polymers of the present invention are preferably conjugated.

Polymers are preferred, which comprise repeating units of the formula 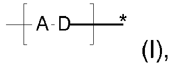 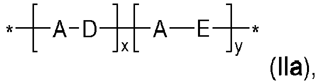 or 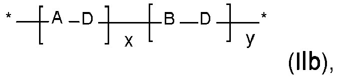 wherein
x = 0.01 to 0.99, y = 0.99 to 0.01, and wherein x + y = 1, A is a group of formula 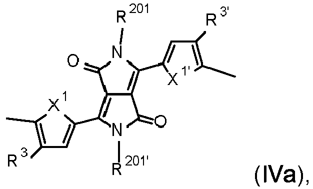 X¹ and X^{1'} are independently of each other O, S, or Se, especially O, or S, very especially
S;
R³ and R^{3'} are independently of each other H, C₁-C₂₅alkyl, C₃-C₁₂cycloalkyl, C₁-C₂₅alkoxy, C₁-C₂₅thioalkyl, C₂-C₂₅alkenyl, or C₂-C₂₅alkynyl, especially H, or C₁-C₂₅alkyl; R²⁰¹ and R^{201'} are independently of each other H, C₁-C₁₀₀alkyl, C₂-C₁₀₀alkenyl, or C₂-C₁₀₀alkynyl, or C₁-C₁₀₀alkyl which is interrupted by -O-, especially C₁-C₁₀₀alkyl;
D is a group of formula 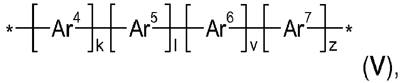 k is 0, or 1,
l is 1,
v is 0, or 1,
z is 0, or 1,
Ar⁴, Ar⁵, Ar⁶ and Ar⁷ are independently of each other a group of formula 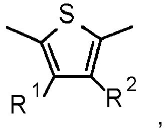 wherein
R¹ and R² are C₁-C₂₅alkoxy, or C₁-C₂₅thioalkyl; or R¹ and R² form together a group 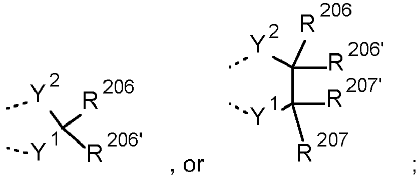 Y¹ and Y² are independently of each other O, or S;
R²⁰⁶, R^{206'}, R²⁰⁷ and R^{207'} are independently of each other H, C₁-C₁₈alkyl, or C₁-C₁₈alkyl which is interrupted one, or more times by O.
E is a group of formula V, which is different from D, and
B is a group of formula V, which is different from D.

In the group of formula (IVa), X¹ and X^{1'} are especially O, or S, R³ and R^{3'} are especially H, or C₁-C₂₅alkyl and R²⁰¹ and R^{201'} are especially C₁-C₁₀₀alkyl;

In the group of formula (IVa), X¹ and X^{1'} are very especially S, R³ and R^{3'} are very especially H and R²⁰¹ and R^{201'} are very especially C₁-C₃₈alkyl.

More preferred, A is a group of formula 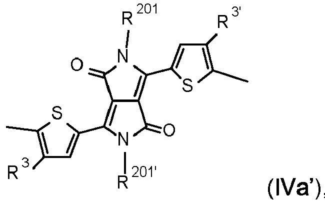 or 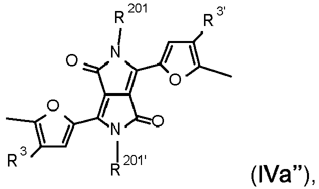 R³ and R^{3'} are independently of each other C₁-C₂₅alkoxy, C₁-C₂₅thioalkyl, especially H, or C₁-C₂₅alkyl, very especially H; and
R²⁰¹ and R^{201'} are independently of each other C₁-C₁₀₀alkyl, very especially C₁-C₃₈alkyl.

In the group of formula (IVa') and (IVa") R³ and R^{3'} are very especially H and R²⁰¹ and R^{201'} are very especially C₁-C₃₈alkyl.

Polymers are also preferred, which comprise repeating units of the formula 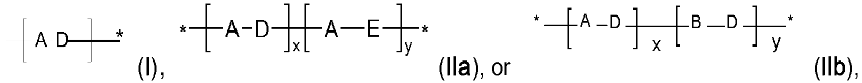 wherein
A is a group of formula 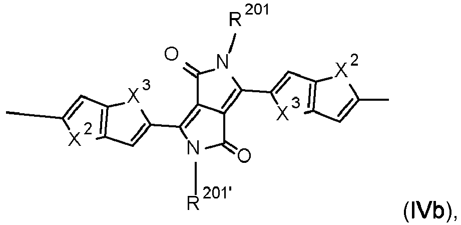 X² and X³ are independently of each other O, S, or Se, especially S;
R²⁰¹ and R^{201'} are independently of each other H, C₁-C₁₀₀alkyl, C₂-C₁₀₀alkenyl, or C₂-C₁₀₀alkynyl, -C₁-C₁₀₀alkyl which is interrupted by -O-; and
x, y, B, D and E are as defined above and below.

More preferred, A is a group of formula 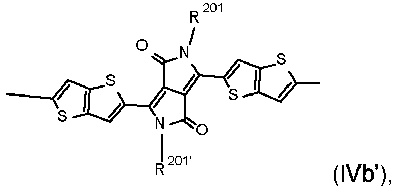 wherein R²⁰¹ and R^{201'} are independently of each other C₁-C₁₀₀alkyl.
R²⁰¹ and R^{201'} are especially C₁-C₃₈alkyl.

D is preferably a group of formula 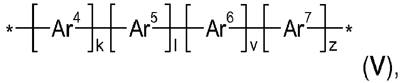 k is 0, or 1,
l is 1,
v is 0, or 1,
z is 0, or 1,
Ar⁴, Ar⁵, Ar⁶ and Ar⁷ are independently of each other a group of formula 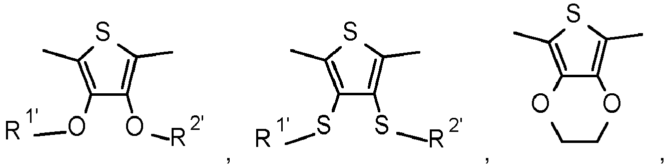 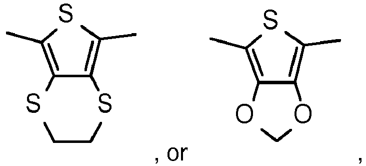 wherein R^{1'} and R^{2'} are C₁-C₂₅alkyl.

Ar⁴, Ar⁵, Ar⁶ and Ar⁷ are preferably a group of formula 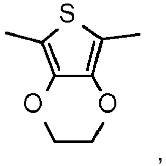 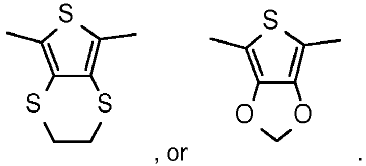 E is preferably a group of formula V, which is different from D. B is preferably a group of formula V, which is different from D.
[Please add preferred groups for B and E!]

Examples of a group of formula (V) are shown below: 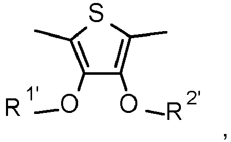 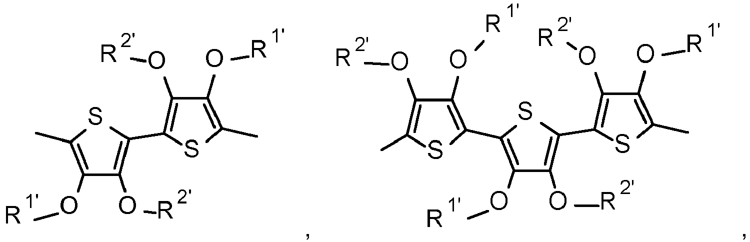 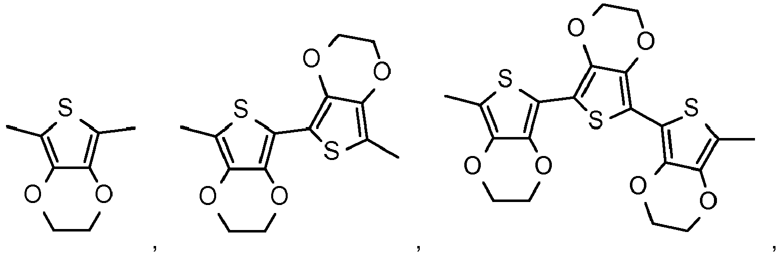 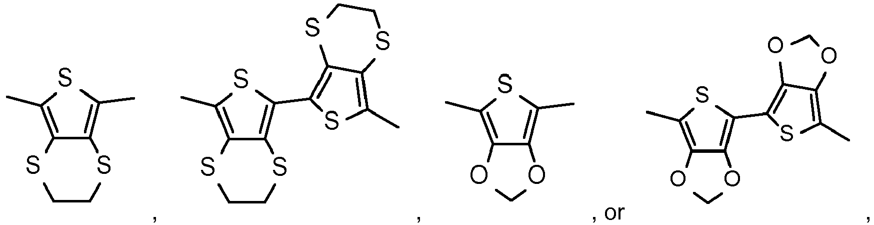 wherein R^{1'} and R^{2'} are C₁-C₂₅alkyl.

Groups of formula 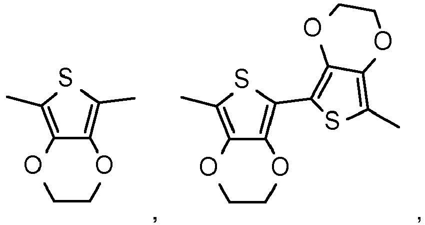 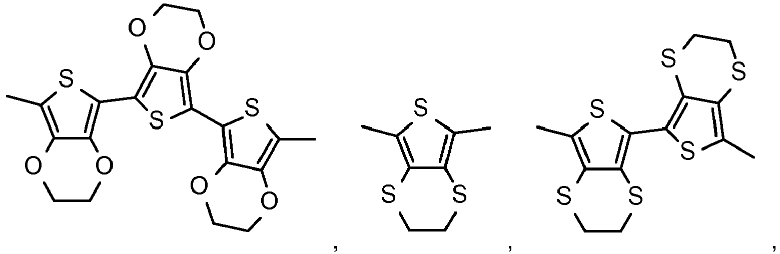 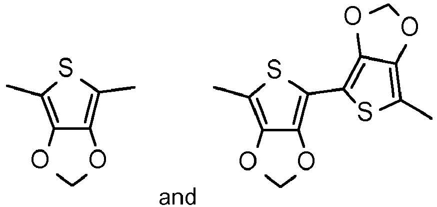 are particularly preferred.

An example of a polymer according to the present invention is a polymer of formula

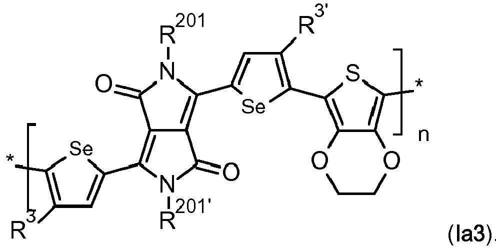

In a particularly preferred embodiment the present invention is directed to polymers of formula: 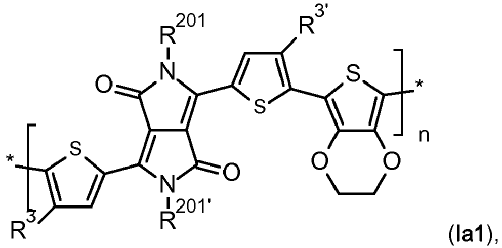 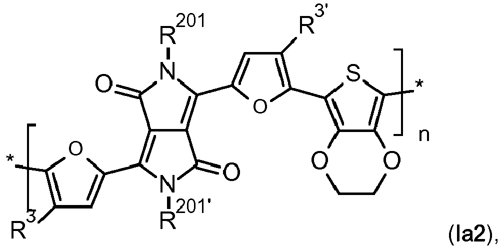 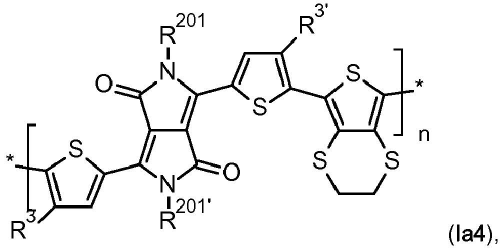 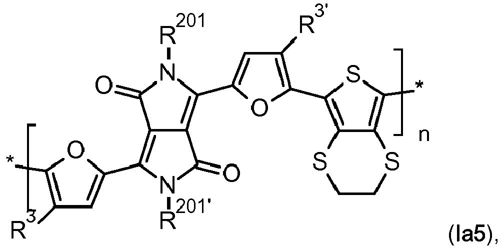 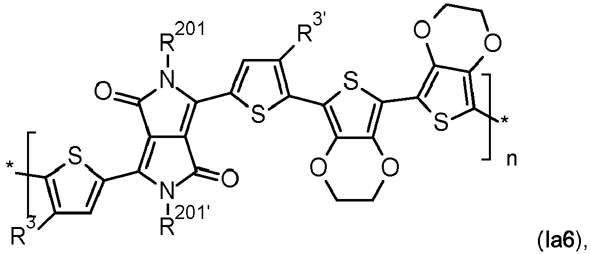 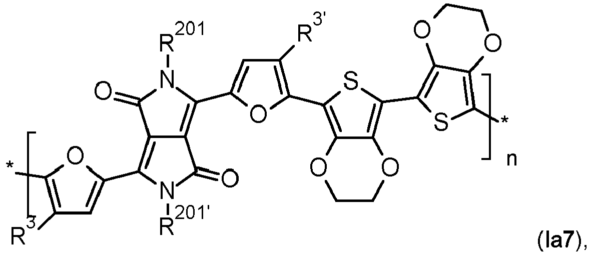 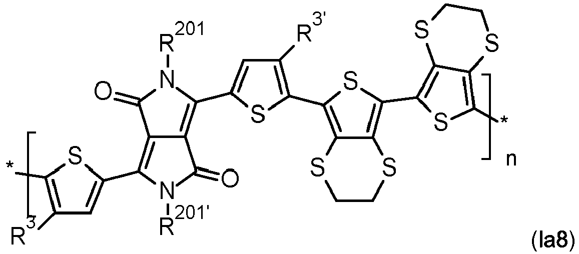 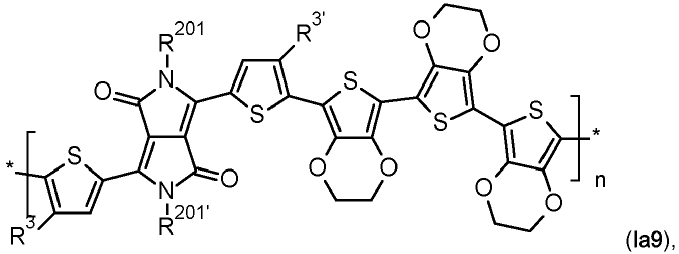 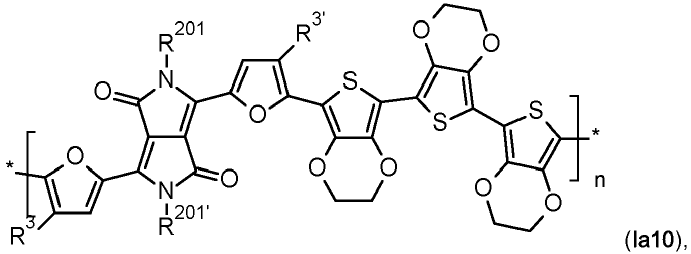 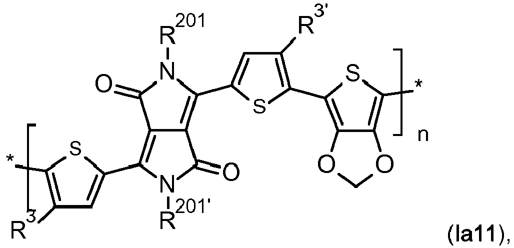 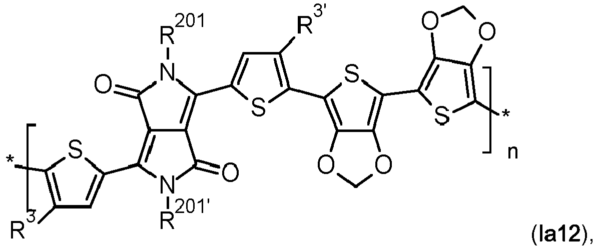 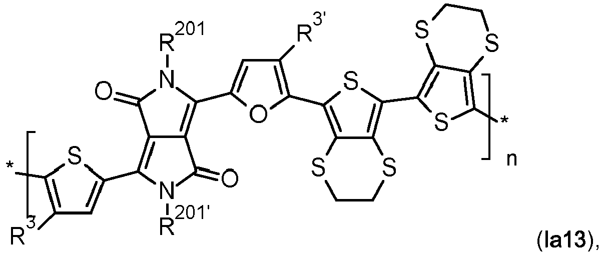 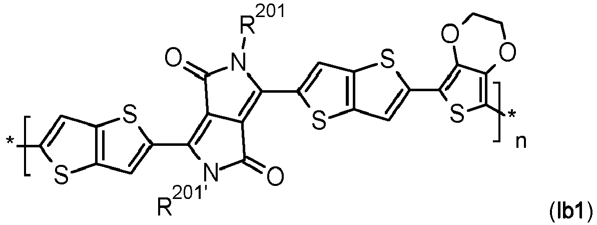 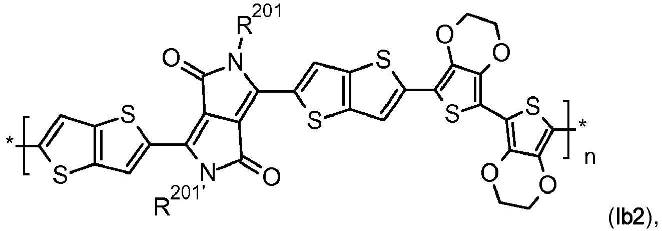 wherein n is 4 to 1000, especially 4 to 200, very especially 5 to 150; R³ and R^{3'} are independently of each other hydrogen or C₁-C₂₅alkyl; R²⁰¹ and R^{201'} are independently of each other C₁-C₁₀₀alkyl.

In the above polymers n is especially 4 to 200;
R³ and R^{3'} are especially the same and are hydrogen or C₁-C₂₅alkyl; and R²⁰¹ and R^{201'} are especially the same and are C₁-C₃₈alkyl.

In the above polymers n is very especially 5 to 150;
R³ and R^{3'} are very especially hydrogen; and
R²⁰¹ and R^{201'} are very especially the same and are C₁-C₃₈alkyl.

Polymers of formula: 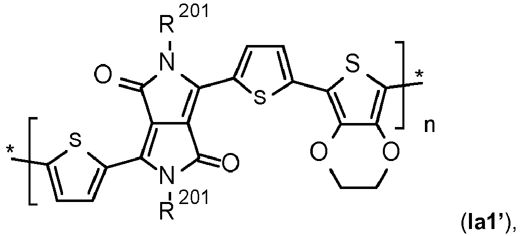 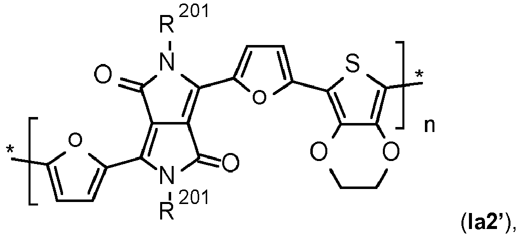 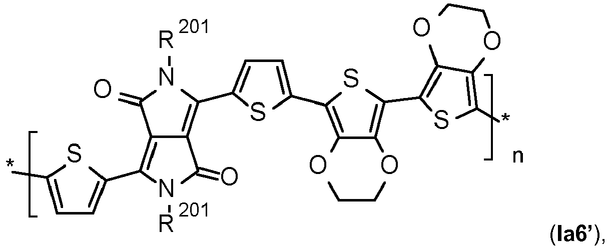 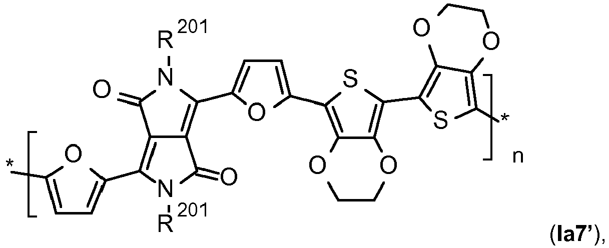 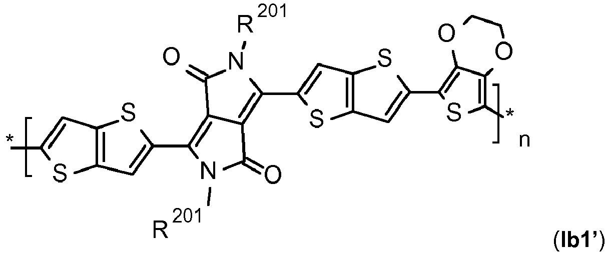 and 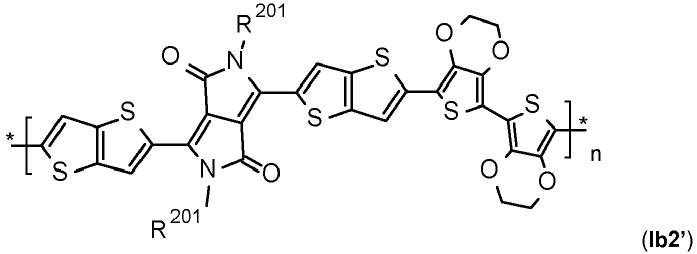 are particulary preferred, wherein
n is 4 to 1000, especially 4 to 200, very especially 5 to 150;
R²⁰¹ is C₁-C₁₀₀alkyl, very especially C₁-C₃₈alkyl.

In the above polymers n is especially 4 to 200 and R²⁰¹ is C₁-C₃₈alkyl. In the above polymers n is very especially 5 to 150 and R²⁰¹ is C₁-C₃₈alkyl.

R²⁰¹ and R^{201'} are preferably a linear, or branched C₁-C₃₈alkyl group, such as, for example, methyl, ethyl, n-propyl, isopropyl, n-butyl, sec.-butyl, isobutyl, tert.-butyl, n-pentyl, 2-pentyl, 3-pentyl, 2,2-dimethylpropyl, 1,1,3,3-tetramethylpentyl, n-hexyl, 1-methylhexyl, 1,1,3,3,5,5-hexamethylhexyl, n-heptyl, isoheptyl, 1,1,3,3-tetramethylbutyl, 1-methylheptyl, 3-methylheptyl, n-octyl, 1,1,3,3-tetramethylbutyl and 2-ethylhexyl, n-nonyl, decyl, undecyl, especially n-dodecyl, tridecyl, tetradecyl, pentadecyl, hexadecyl, 2-ethyl-hexyl, 2-butyl-hexyl, 2-butyl-octyl, 2-hexyldecyl, 2-decyl-tetradecyl, heptadecyl, octadecyl, eicosyl, heneicosyl, docosyl, or tetracosyl. R²⁰¹ and R^{201'} may be different, but are preferably the same.

Advantageously, the groups R²⁰¹ and R^{201'} can be represented by formula 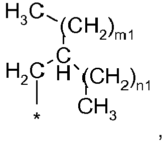 wherein m1 = n1 + 2 and m1 + n1 ≤ 24. Chiral side chains can either be homochiral, or racemic, which can influence the morphology of the compounds.

Examples of polymers of the present invention are shown below:

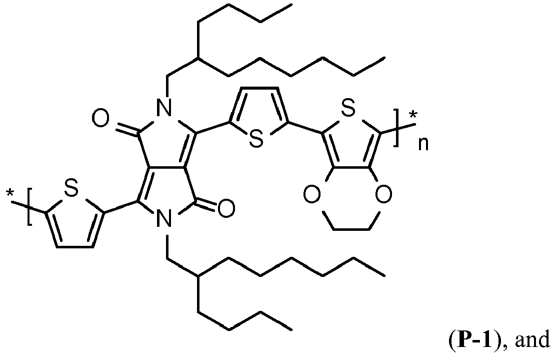

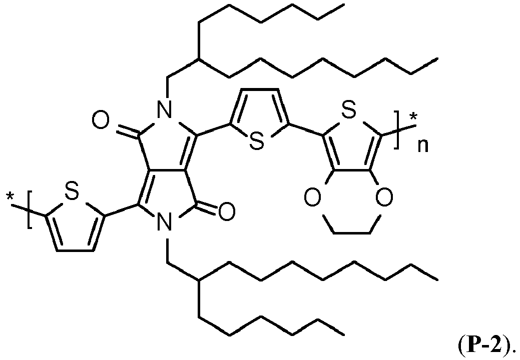

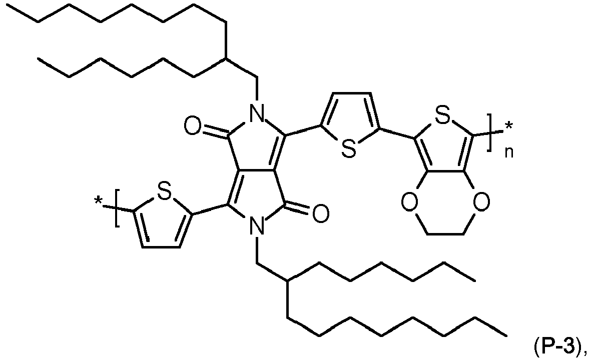

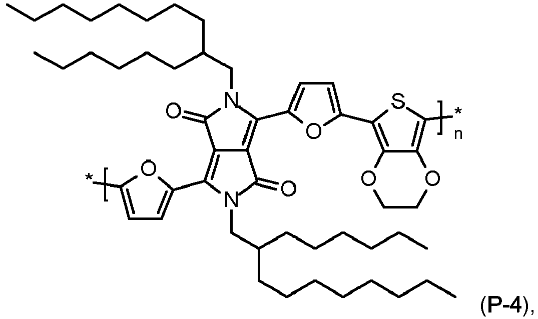

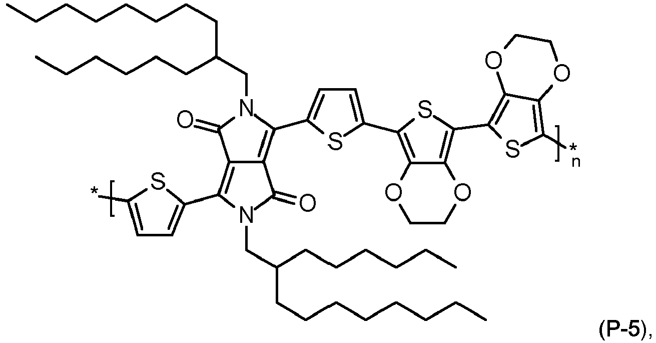

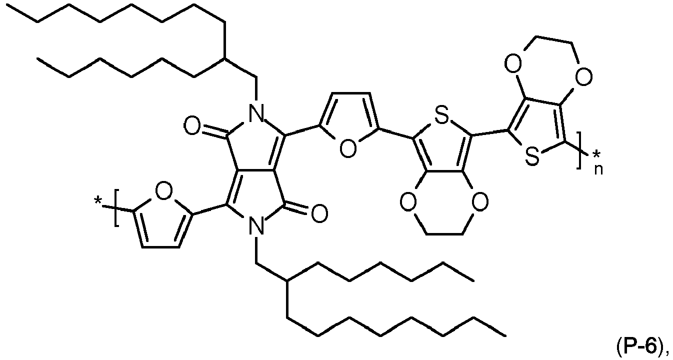

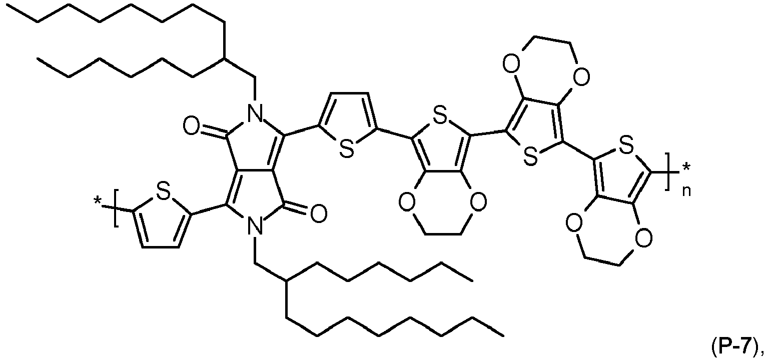

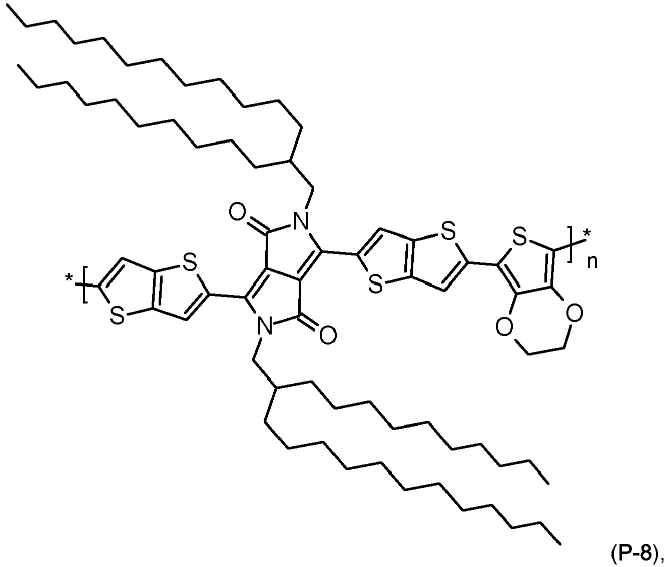

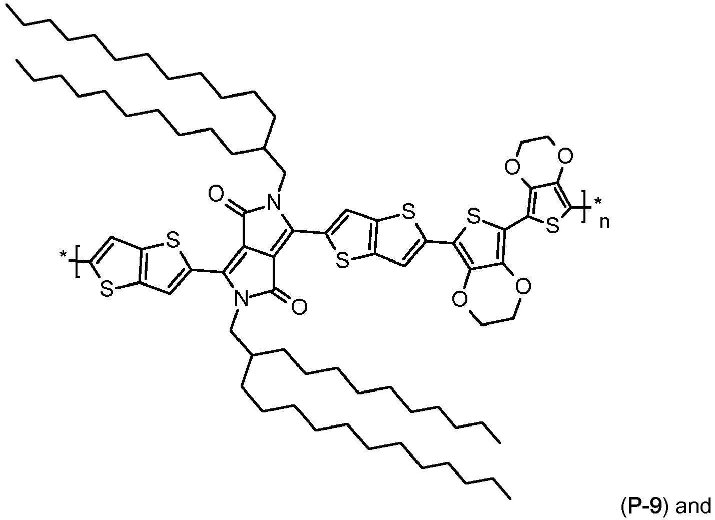

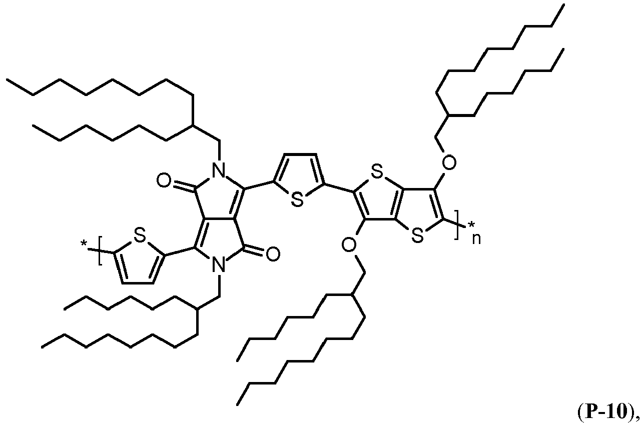

In the above polymers n is especially 4 to 200; very especially 5 to 150.

Copolymers of formula 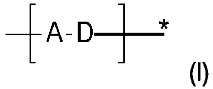 can be obtained, for example, by the Suzuki reaction. The condensation reaction of an aromatic boronate and a halogenide, especially a bromide, commonly referred to as the "Suzuki reaction", is tolerant of the presence of a variety of organic functional groups as reported by N. Miyaura and A. Suzuki in Chemical Reviews, Vol. 95, pp. 457-2483 (1995). Preferred catalysts are 2-dicyclohexylphosphino-2',6'-di-alkoxybiphenyl/palladium(II)acetates, tri-alykl-phosphonium salts/palladium (0) derivatives and tri-alkylphosphine/palladium (0) derivatives. Especially preferred catalysts are 2-dicyclohexylphosphino-2',6'-di-methoxybiphenyl (sPhos)/palladium(II)acetate and, tri-tert-butylphosphonium tetrafluoroborate ((t-Bu)₃P * HBF₄)/tris(dibenzylideneacetone) dipalladium (0) (Pd₂(dba)₃) and tri-tert-butylphosphine (t-Bu)₃P/tris(dibenzylideneacetone) dipalladium (0) (Pd₂(dba)₃). This reaction can be applied to preparing high molecular weight polymers and copolymers.

To prepare polymers corresponding to formula (I) (COM¹ is D) a dihalogenide of formula X¹⁰-A-X¹⁰ is reacted with an (equimolar) amount of a diboronic acid or diboronate corresponding to formula 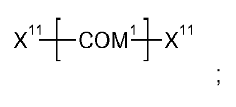 or a dihalogenide of formula 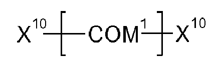 is reacted with an (equimolar) amount of a diboronic acid or diboronate corresponding to formula X¹¹-A-X¹¹, wherein X¹⁰ is halogen, especially Br, and X¹¹ is
independently in each occurrence -B(OH)₂, -B(OY¹)₂, 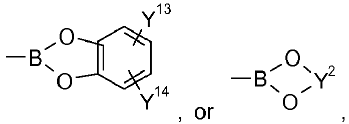 wherein Y¹ is independently in each occurrence a C₁-C₁₀alkyl group and Y² is independently in each occurrence a C₂-C₁₀alkylene group, such as -CY³Y⁴-CY⁵Y⁶-, or - CY⁷Y⁸-CY⁹Y¹⁰- CY¹¹Y¹²-, wherein Y³, Y⁴, Y⁵, Y⁶, Y⁷, Y⁸, Y⁹, Y¹⁰, Y¹¹ and Y¹² are independently of each other hydrogen, or a C₁-C₁₀alkyl group, especially -C(CH₃)₂C(CH₃)₂-, -CH₂C(CH₃)₂CH₂-, or -C(CH₃)₂CH₂C(CH₃)₂-, and Y¹³ and Y¹⁴ are independently of each other hydrogen, or a C₁-C₁₀alkyl group, under the catalytic action of Pd and triphenylphosphine. The reaction is typically conducted at about 0 °C to 180 °C in an aromatic hydrocarbon solvent such as toluene, xylene. Other solvents such as dimethylformamide, dioxane, dimethoxyethan and tetrahydrofuran can also be used alone, or in mixtures with an aromatic hydrocarbon. An aqueous base, preferably sodium carbonate or bicarbonate, potassium phosphate, potassium carbonate or bicarbonate is used as activation agent for the boronic acid, boronate and as the HBr scavenger. A polymerization reaction may take 0.2 to 100 hours. Organic bases, such as, for example, tetraalkylammonium hydroxide, and phase transfer catalysts, such as, for example TBAB, can promote the activity of the boron (see, for example, Leadbeater & Marco; Angew. Chem. Int. Ed. Eng. 42 (2003) 1407 and references cited therein). Other variations of reaction conditions are given by T. I. Wallow and B. M. Novak in J. Org. Chem. 59 (1994) 5034-5037; and M. Remmers, M. Schulze, and G. Wegner in Macromol. Rapid Commun. 17 (1996) 239-252. Controll of molecular weight is possible by using either an excess of dibromide, diboronic acid, or diboronate, or a chain terminator.

According to the process described in WO2010/136352 the polymerisation is carried out in presence of
a) a catalyst/ligand system comprising a palladium catalyst and an organic phosphine or phosphonium compound,
b) a base,
c) a solvent or a mixture of solvents, characterized in that
the organic phosphine is a trisubstituted phosphine of formula 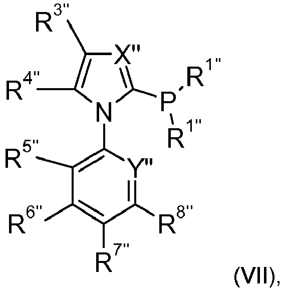 or phosphonium salt thereof, wherein X" independently of Y" represents a nitrogen atom or a C-R^{2"} group and Y" independently of X" represents a nitrogen atom or a C-R^{9"} group, R^{1"} for each of the two R^{1"} groups independently of the other represents a radical selected from the group C₁-C₂₄-alkyl, C₃-C₂₀-cycloalkyl, which includes especially both monocyclic and also bi-and tri-cyclic cycloalkyl radicals, C₅-C₁₄-aryl, which includes especially the phenyl, naphthyl, fluorenyl radical, C₂-C₁₃-heteroaryl, wherein the number of hetero atoms, selected from the group N, O, S, may be from 1 to 2, wherein the two radicals R^{1"} may also be linked to one another, and wherein the above-mentioned radicals R^{1"} may themselves each be mono-or polysubstituted independently of one another by substituents selected from the group hydrogen, C₁-C₂₀-alkyl, C₂-C₂₀-alkenyl, C₃-C₈-cycloalkyl, C₂-C₉-hetero-alkyl, C₅-C₁₀-aryl, C₂-C₉-heteroaryl, wherein the number of hetero atoms from the group N, O, S may be from 1 to 4, C₁-C₂₀-alkoxy, C₁-C₁₀-haloalkyl, hydroxy, amino of the forms NH-(C₁-C₂₀-alkyl), NH-(C₅-C₁₀-aryl), N(C₁-C₂₀-alkyl)₂, N(C₁-C₂₀-alkyl) (C₅-C₁₀-aryl), N(C₅-C₁₀-aryl)₂, N(C₁-C₂₀-alkyl/C₅-C₁₀-aryl₃)₃⁺, NH-CO-C₁-C₂₀-alkyl, NH-CO- C₅-C₁₀-aryl, carboxylato of the forms COOH and COOQ (wherein Q represents either a monovalent cation or C₁-C₈-alkyl), C₁-C₆-acyloxy, sulfinato, sulfonato of the forms SO₃H and SO₃Q' (wherein Q' represents either a monovalent cation, C₁-C₂₀-alkyl, or C₅-C₁₀-aryl), tri-C₁-C₆-alkylsilyl, wherein two of the mentioned substituents may also be bridged with one another, R^{2"}-R^{9"} represent a hydrogen, alkyl, alkenyl, cycloalkyl, aromatic or heteroaromatic aryl, O-alkyl, NH- alkyl, N-(alkyl)₂, O-(aryl), NH-(aryl), N-(alkyl)(aryl), O-CO-alkyl, O-CO-aryl, F, Si(alkyl)₃, CF₃, CN, CO₂H, COH, SO₃H, CONH₂, CONH(alkyl), CON(alkyl)₂, SO₂(alkyl), SO(alkyl), SO(aryl), SO₂(aryl), SO₃(alkyl), SO₃(aryl), S-alkyl, S-aryl, NH-CO(alkyl), CO₂(alkyl), CONH₂, CO(alkyl), NHCOH, NHCO₂(alkyl), CO(aryl), CO₂(aryl) radical, wherein two or more adjacent radicals, each independently of the other (s), may also be linked to one another so that a condensed ring system is present and wherein in R^{2"} to R^{9"} alkyl represents a hydrocarbon radical having from 1 to 20 carbon atoms which may in each case be linear or branched, alkenyl represents a mono-or poly- unsaturated hydrocarbon radical having from 2 to 20 carbon atoms which may in each case be linear or branched, cycloalkyl represents a hydrocarbon having from 3 to 20 carbon atoms, aryl represents a 5- to 14-membered aromatic radical, wherein from one to four carbon atoms in the aryl radical may also be replaced by hetero atoms from the group nitrogen, oxygen and sulfur so that a 5- to 14-membered heteroaromatic radical is present, wherein the radicals R^{2"} to R^{9"} may also carry further substituents as defined for R^{1"}.

The organic phosphines and their synthesis are described in WO2004101581.

Preferred organic phosphines are selected from trisubstituted phosphines of formula

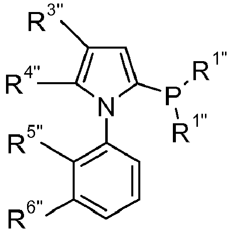

| Cpd. | R^{1"} | R^{5"} | R^{6"} | R^{3"} | R^{4"} |
|---|---|---|---|---|---|
| A-1 | 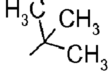 | H | H | H | H |
| A-2 | cyclohexyl | H | H | H | H |
| A-3 | phenyl | H | H | H | H |
| A-4 | adamantyl | H | H | H | H |
| A-5 | cyclohexyl | -OCH₃ | H | H | H |
| A-6 | cyclohexyl | ¹⁾ | ¹⁾ | H | H |
| A-7 | 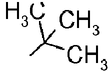 | ¹⁾ | ¹⁾ | H | H |
| A-8 | phenyl | ¹⁾ | ¹⁾ | H | H |
| A-9 | adamantyl | ¹⁾ | ¹⁾ | H | H |
| **A-10** | cyclohexyl | H | H | ²⁾ | ²⁾ |
| **A-11** | 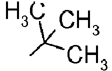 | H | H | ²⁾ | ²⁾ |
| **A-12** | phenyl | H | H | ²⁾ | ²⁾ |
| **A-13** | adamantyl | H | H | ²⁾ | ²⁾ |

¹⁾ R^{5"} and R^{6"} together form a ring 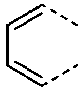 ²⁾ R^{3"} and R^{4"} together form a ring

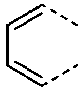

Examples of preferred catalysts include the following compounds:
palladium(II) acetylacetonate, palladium(0) dibenzylidene-acetone complexes, palladium(II) propionate,
Pd₂(dba)₃: [tris(dibenzylideneacetone) dipalladium(0)],
Pd(dba)₂: [bis(dibenzylideneacetone) palladium(0)],
Pd(PR₃)₂, wherein PR₃ is a trisubstituted phosphine of formula VII,
Pd(OAc)₂: [palladium(II) acetate], palladium(II) chloride, palladium(II) bromide, lithium tetrachloropalladate(II),
PdCl₂(PR₃)₂; wherein PR₃ is a trisubstituted phosphine of formula VII; palladium(0) diallyl ether complexes, palladium(II) nitrate,
PdCl₂(PhCN)₂: [dichlorobis(benzonitrile) palladium(II)],
PdCl₂(CH₃CN): [dichlorobis(acetonitrile) palladium(II)], and
PdCl₂(COD): [dichloro(1,5-cyclooctadiene) palladium(II)].

Especially preferred are PdCl₂, Pd₂(dba)₃, Pd(dba)₂, Pd(OAc)₂, or Pd(PR₃)₂. Most preferred are Pd₂(dba)₃ and Pd(OAc)₂.

The palladium catalyst is present in the reaction mixture in catalytic amounts. The term "catalytic amount" refers to an amount that is clearly below one equivalent of the (hetero)aromatic compound(s), preferably 0.001 to 5 mol-%, most preferably 0.001 to 1 mol-%, based on the equivalents of the (hetero)aromatic compound(s) used.

The amount of phosphines or phosphonium salts in the reaction mixture is preferably from 0.001 to 10 mol-%, most preferably 0.01 to 5 mol-%, based on the equivalents of the (hetero)aromatic compound(s) used. The preferred ratio of Pd:phosphine is 1:4.

The base can be selected from all aqueous and nonaqueous bases and can be inorganic, or organic. It is preferable that at least 1.5 equivalents of said base per functional boron group is present in the reaction mixture. Suitable bases are, for example, alkali and alkaline earth metal hydroxides, carboxylates, carbonates, fluorides and phosphates such as sodium and potassium hydroxide, acetate, carbonate, fluoride and phosphate or also metal alcoholates. It is also possible to use a mixture of bases. The base is preferably a lithium salt, such as, for example, lithium alkoxides (such as, for example, lithium methoxide and lithium ethoxide), lithium hydroxide, carboxylate, carbonate, fluoride and/or phosphate.

The at present most preferred base is aqueous LiOHxH₂O (monohydrate of LiOH) and (waterfree) LiOH.

The reaction is typically conducted at about 0 °C to 180°C, preferably from 20 to 160°C, more preferably from 40 to 140°C and most preferably from 40 to 120°C. A polymerization reaction may take 0.1, especially 0.2 to 100 hours.

In a preferred embodiment of the present invention the solvent is THF, the base is LiOH*H₂O and the reaction is conducted at reflux temperature of THF (about 65 °C).

The solvent is for example selected from toluene, xylenes, anisole, THF, 2-methyltetrahydrofuran, dioxane, chlorobenzene, fluorobenzene or solvent mixtures comprising one or more solvents like e.g. THF/toluene and optionally water. Most preferred is THF, or THF/water.

Advantageously, the polymerisation is carried out in presence of
a) palladium(II) acetate, or Pd₂(dba)₃, (tris(dibenzylideneacetone)dipalladium(0)) and an organic phosphine A-1 to A-13,
b) LiOH, or LiOHxH₂O; and
c) THF, and optionally water. If the monohydrate of LiOH is used, no water needs to be added. The palladium catalyst is present in an amount of preferably about 0.5 mol-%, based on the equivalents of the (hetero)aromatic compound(s) used. The amount of phosphines or phosphonium salts in the reaction mixture is preferably about 2 mol-%, based on the equivalents of the (hetero)aromatic compound(s) used. The preferred ratio of Pd:phosphine is about 1:4.

Preferably the polymerization reaction is conducted under inert conditions in the absence of oxygen. Nitrogen and more preferably argon are used as inert gases.

The process described in WO2010/136352 is suitable for large-scale applications, is readily accessible and convert starting materials to the respective polymers in high yield, with high purity and high selectivity. The process can provide polymers having weight average molecular weights of at least 10,000, more preferably at least 20,000, most preferably at least 30,000. The at present most preferred polymers have a weight average molecular weight of 30,000 to 80,000 Daltons. Molecular weights are determined according to high-temperature gel permeation chromatography (HT-GPC) using polystyrene standards. The polymers preferably have a polydispersibility of 1.01 to 10, more preferably 1.1 to 3.0, most preferred 1.5 to 2.5.

If desired, a monofunctional aryl halide or aryl boronate, such as, for example, 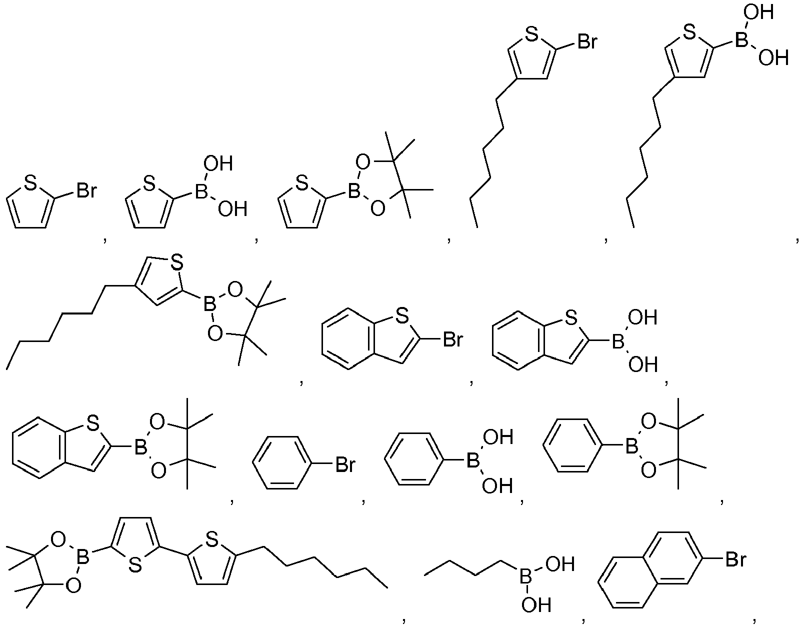 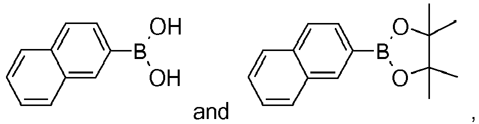 may be used as a chain-terminator in
such reactions, which will result in the formation of a terminal aryl group.

It is possible to control the sequencing of the monomeric units in the resulting copolymer by controlling the order and composition of monomer feeds in the Suzuki reaction.

The polymers of the present invention can also be synthesized by the Stille coupling (see, for example, Babudri et al, J. Mater. Chem., 2004, 14, 11-34; J. K. Stille, Angew. Chemie Int. Ed. Engl. 1986, 25, 508). To prepare polymers corresponding to formula (I) a dihalogenide of formula X¹⁰-A-X¹⁰ is reacted with a compound of formula X^{11'}-COM¹-X^{11'}, or a dihalogenide of formula X¹⁰-COM¹-X¹⁰ is reacted with a compound of formula X^{11'}-A-X^{11'}, wherein X^{11'} is a group -SnR³⁰⁷R³⁰⁸R³⁰⁹ and X¹⁰ is as defined above, in an inert solvent at a temperature in range from 0°C to 200°C in the presence of a palladium-containing catalyst, wherein R³⁰⁷, R³⁰⁸ and R³⁰⁹ are identical or different and are H or C₁C₆alkyl, wherein two radicals optionally form a common ring and these radicals are optionally branched or unbranched. It must be ensured here that the totality of all monomers used has a highly balanced ratio of organotin functions to halogen functions. In addition, it may prove advantageous to remove any excess reactive groups at the end of the reaction by end-capping with monofunctional reagents. In order to carry out the process, the tin compounds and the halogen compounds are preferably introduced into one or more inert organic solvents and stirred at a temperature of from 0 to 200°C, preferably from 30 to 170°C for a period of from 1 hour to 200 hours, preferably from 5 hours to 150 hours. The crude product can be purified by methods known to the person skilled in the art and appropriate for the respective polymer, for example repeated reprecipitation or even by dialysis.

Suitable organic solvents for the process described are, for example, ethers, for example diethyl ether, dimethoxyethane, diethylene glycol dimethyl ether, tetrahydrofuran, dioxane, dioxolane, diisopropyl ether and tert-butyl methyl ether, hydrocarbons, for example hexane, isohexane, heptane, cyclohexane, benzene, toluene and xylene, alcohols, for example methanol, ethanol, 1-propanol, 2-propanol, ethylene glycol, 1-butanol, 2-butanol and tert-butanol, ketones, for example acetone, ethyl methyl ketone and isobutyl methyl ketone, amides, for example dimethylformamide (DMF), dimethylacetamide and N-methylpyrrolidone, nitriles, for example acetonitrile, propionitrile and butyronitrile, and mixtures thereof.

The palladium and phosphine components should be selected analogously to the description for the Suzuki variant.

Alternatively, the polymers of the present invention can also be synthesized by the Negishi reaction using a zinc reagent A-(ZnX¹²)₂, wherein X¹² is halogen and halides, and COM¹-(X²³)₂, wherein X²³ is halogen or triflate, or using A-(X²³)₂ and COM¹-(ZnX²³)₂. Reference is, for example, made to E. Negishi et al., Heterocycles 18 (1982) 117-22.

Alternatively, the polymers of the present invention can also be synthesized by the Hiyama reaction using a organosilicon reagent A-(SiR²¹⁰R²¹¹R²¹²)₂, wherein R²¹⁰, R²¹¹ and R²¹² are identical or different and are halogen, or C₁-C₆alkyl, and COM¹-(X²³)₂, wherein X²³ is halogen or triflate, or using A-(X²³)₂ and COM¹-(SiR²¹⁰R²¹¹R²¹²)₂. Reference is, for example, made to T. Hiyama et al., Pure Appl. Chem. 66 (1994) 1471-1478 and T. Hiyama et al., Synlett (1991) 845-853.

Halogen is fluorine, chlorine, bromine and iodine.

The C₁-C₁₀₀alkyl group is preferably a C₁-C₃₈alkyl group, especially a C₁-C₂₅alkyl group. Reference is made to the definition of R²⁰¹.

C₁-C₂₅alkyl (C₁-C₁₈alkyl) is typically linear or branched, where possible. Examples are methyl, ethyl, n-propyl, isopropyl, n-butyl, sec.-butyl, isobutyl, tert.-butyl, n-pentyl, 2-pentyl, 3-pentyl, 2,2-dimethylpropyl, 1,1,3,3-tetramethylpentyl, n-hexyl, 1-methylhexyl, 1,1,3,3,5,5-hexamethylhexyl, n-heptyl, isoheptyl, 1,1,3,3-tetramethylbutyl, 1-methylheptyl, 3-methylheptyl, n-octyl, 1,1,3,3-tetramethylbutyl and 2-ethylhexyl, n-nonyl, decyl, undecyl, dodecyl, tridecyl, tetradecyl, pentadecyl, hexadecyl, heptadecyl, octadecyl, eicosyl, heneicosyl, docosyl, tetracosyl or pentacosyl. C₁-C₈alkyl is typically methyl, ethyl, n-propyl, isopropyl, n-butyl, sec.-butyl, isobutyl, tert.-butyl, n-pentyl, 2-pentyl, 3-pentyl, 2,2-dimethyl-propyl, n-hexyl, n-heptyl, n-octyl, 1,1,3,3-tetramethylbutyl and 2-ethylhexyl. C₁-C₄alkyl is typically methyl, ethyl, n-propyl, isopropyl, n-butyl, sec.-butyl, isobutyl, tert.-butyl.

The C₂-C₁₀₀alkenyl group is preferably a C₁-C₂₅alkenyl group (C₂-C₁₈alkenyl). C₂-C₂₅alkenyl (C₂-C₁₈alkenyl) groups are straight-chain or branched alkenyl groups, such as e.g. vinyl, allyl, methallyl, isopropenyl, 2-butenyl, 3-butenyl, isobutenyl, n-penta-2,4-dienyl, 3-methyl-but-2-enyl, n-oct-2-enyl, n-dodec-2-enyl, isododecenyl, n-dodec-2-enyl or n-octadec-4-enyl.

The C₂-C₁₀₀alkynyl group is preferably a C₁-C₂₅alkynyl group (C₂-C₁₈alkynyl). C₂₋₂₅alkynyl (C₂-₁₈alkynyl) is straight-chain or branched and preferably C₂₋₈alkynyl, which may be unsubstituted or substituted, such as, for example, ethynyl, 1-propyn-3-yl, 1-butyn-4-yl, 1-pentyn-5-yl, 2-methyl-3-butyn-2-yl, 1,4-pentadiyn-3-yl, 1,3-pentadiyn-5-yl, 1-hexyn-6-yl, cis-3-methyl-2-penten-4-yn-1-yl, trans-3-methyl-2-penten-4-yn-1-yl, 1,3-hexadiyn-5-yl, 1-octyn-8-yl, 1-nonyn-9-yl, 1-decyn-10-yl, or 1-tetracosyn-24-yl.

A halogenated C₁-C₁₀₀alkyl group is preferably a halogenated C₁-C₂₅alkyl group, which is a branched or unbranched radical, wherein all, or part of the hydrogen atoms of the corresponding alkyl group have been replaced by halogen atoms, such as, for example,-CF₃, -CF₂CF₃, -CF₂CF₂CF₃, -CF(CF₃)₂, -(CF₂)₃CF₃, and -C(CF₃)₃.

The C₁-C₁₀₀alkoxy group is preferably a C₁-C₃₈alkoxy group, especially a C₁-C₂₅alkoxy group. C₁-C₂₅alkoxy groups (C₁-C₁₈alkoxy groups) are straight-chain or branched alkoxy groups, e.g. methoxy, ethoxy, n-propoxy, isopropoxy, n-butoxy, sec-butoxy, tert-butoxy, amyloxy, isoamyloxy or tert-amyloxy, heptyloxy, octyloxy, isooctyloxy, nonyloxy, decyloxy, undecyloxy, dodecyloxy, tetradecyloxy, pentadecyloxy, hexadecyloxy, heptadecyloxy and octadecyloxy. Examples of C₁-C₈alkoxy are methoxy, ethoxy, n-propoxy, isopropoxy, n-butoxy, sec.-butoxy, isobutoxy, tert.-butoxy, n-pentoxy, 2-pentoxy, 3-pentoxy, 2,2-dimethylpropoxy, n-hexoxy, n-heptoxy, n-octoxy, 1,1,3,3-tetramethylbutoxy and 2-ethylhexoxy, preferably C₁-C₄alkoxy such as typically methoxy, ethoxy, n-propoxy, isopropoxy, n-butoxy, sec.-butoxy, isobutoxy, tert.-butoxy. The term "alkylthio group" means the same groups as the alkoxy groups, except that the oxygen atom of the ether linkage is replaced by a sulfur atom.

The term "carbamoyl group" is typically a C₁₋₁₈carbamoyl radical, preferably C₁₋₈carbamoyl radical, which may be unsubstituted or substituted, such as, for example, carbamoyl, methylcarbamoyl, ethylcarbamoyl, n-butylcarbamoyl, tert-butylcarbamoyl, dimethylcarbamoyloxy, morpholinocarbamoyl or pyrrolidinocarbamoyl.

A cycloalkyl group is typically C₅-C₁₂cydoalkyl, such as, for example, cyclopentyl, cyclohexyl, cycloheptyl, cyclooctyl, cyclononyl, cyclodecyl, cycloundecyl, cyclododecyl, preferably cyclopentyl, cyclohexyl, cycloheptyl, or cyclooctyl, which may be unsubstituted or substituted.

C₆-C₂₄aryl (C₆-C₁₈aryl) is typically phenyl, indenyl, azulenyl, naphthyl, biphenyl, as-indacenyl, s-indacenyl, acenaphthylenyl, fluorenyl, phenanthryl, fluoranthenyl, triphenlenyl, chrysenyl, naphthacen, picenyl, perylenyl, pentaphenyl, hexacenyl, pyrenyl, or anthracenyl, preferably phenyl, 1-naphthyl, 2-naphthyl, 4-biphenyl, 9-phenanthryl, 2- or 9-fluorenyl, 3- or 4-biphenyl, which may be unsubstituted or substituted. Examples of C₆-C₁₂aryl are phenyl, 1-naphthyl, 2-naphthyl, 3- or 4-biphenyl, 2- or 9-fluorenyl or 9-phenanthryl, which may be unsubstituted or substituted.

C₇-C₂₅aralkyl is typically benzyl, 2-benzyl-2-propyl, β-phenyl-ethyl, α,α-dimethylbenzyl, ω-phenyl-butyl, ω,ω-dimethyl-ω-phenyl-butyl, ω-phenyl-dodecyl, ω-phenyl-octadecyl, ω-phenyl-eicosyl or ω-phenyl-docosyl, preferably C₇-C₁₈aralkyl such as benzyl, 2-benzyl-2-propyl, β-phenyl-ethyl, α,α-dimethylbenzyl, ω-phenyl-butyl, ω,ω-dimethyl-ω-phenyl-butyl, ω-phenyl-dodecyl or ω-phenyl-octadecyl, and particularly preferred C₇-C₁₂aralkyl such as benzyl, 2-benzyl-2-propyl, β-phenyl-ethyl, α,α-dimethylbenzyl, ω-phenyl-butyl, or ω,ω-dimethyl-ω-phenyl-butyl, in which both the aliphatic hydrocarbon group and aromatic hydrocarbon group may be unsubstituted or substituted. Preferred examples are benzyl, 2-phenylethyl, 3-phenylpropyl, naphthylethyl, naphthylmethyl, and cumyl.

Possible substituents of the above-mentioned groups are C₁-C₈alkyl, a hydroxyl group, a mercapto group, C₁-C₈alkoxy, C₁-C₈alkylthio, halogen, halo-C₁-C₈alkyl, a cyano group, a carbamoyl group, a nitro group or a silyl group, especially C₁-C₈alkyl, C₁-C₈alkoxy, C₁-C₈alkylthio, halogen, halo-C₁-C₈alkyl, or a cyano group.

C₁-C₂₅alkyl (C₁-C₁₈alkyl) interrupted by one or more O is, for example, (CH₂CH₂O)₁₋₉-R^{x}, where R^{x} is H or C₁-C₁₀alkyl, CH₂-CH(OR^{y'})-CH₂-O-R^{y}, where R^{y} is C₁-C₁₈alkyl, and R^{y'} embraces the same definitions as R^{y} or is H.

If a substituent, such as, for example R³, occurs more than one time in a group, it can be different in each occurrence.

The present invention also relates to the use of the polymers of the present invention, especially the polymers of formula (I), very especially polymers of formula **(Ia1)** to **(Ia13)** as well as **(Ib1)** and **(Ib2),** in an organic, electronic device.

The organic, electronic device is, for example, an organic electroluminescent device (OLED), a polymeric electroluminescent device (PLED), an organic integrated circuit (O--IC), an organic field-effect transistor (O-FET), an organic thin-film transistor (O-TFT), an organic light-emitting transistor (O-LET), an organic solar cell (O-SC), an organic optical detector, an organic photoreceptor, an organic field-quench device (O-FQD), a light-emitting electrochemical cell (LEC), or an organic laser diode (O-laser).

For the purposes of the present invention, it is preferred for the polymer according to the invention to be in the form of a layer (or to be present in a layer) in the electronic device. The polymer according to the invention can be present in the form of a hole-transport, holeinjection, emitter, electron-transport, electron-injection, charge-blocking and/or charge-generation layer. The polymers according to the invention may be, for example, employed as emitting compounds in an emitting layer.

It may additionally be preferred to use the polymer not as the pure substance, but instead as a mixture (blend) together with further polymeric, oligomeric, dendritic or low-molecularweight substances of any desired type. These may, for example, improve the electronic properties.

A mixture containing a polymer of the present invention results in a semi-conducting layer comprising a polymer of the present invention (typically 5% to 99.9999% by weight, especially 20 to 85 % by weight) and at least another material. The other material can be, but is not restricted to a fraction of the same polymer of the present invention with different molecular weight, another polymer of the present invention, a semi-conducting polymer, organic small molecules, carbon nanotubes, a fullerene derivative, inorganic particles (quantum dots, quantum rods, quantum tripods, TiO₂, ZnO etc.), conductive particles (Au, Ag etc.), insulator materials like the ones described for the gate dielectric (PET, PS etc.). The polymers of the present invention can be blended with small molecules described, for example, in WO2009/047104, WO2010108873, WO2012/041849, WO09/047104, US6,690,029, WO2007082584, and WO2008107089: WO2007082584:

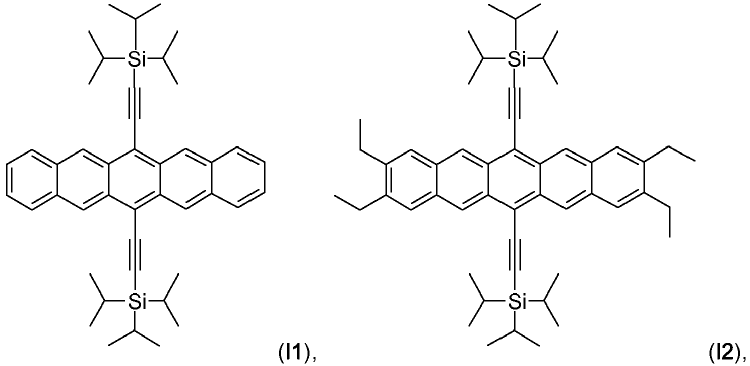

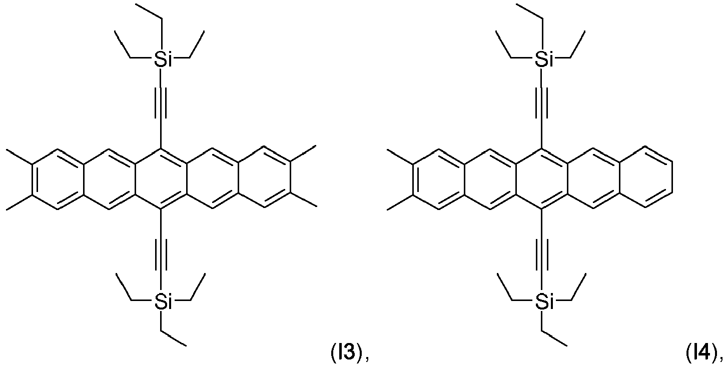

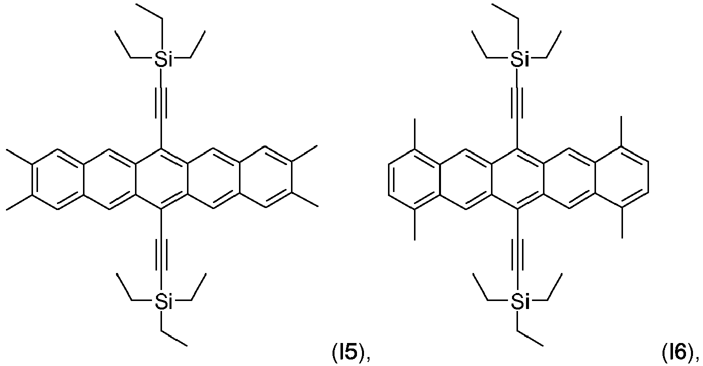

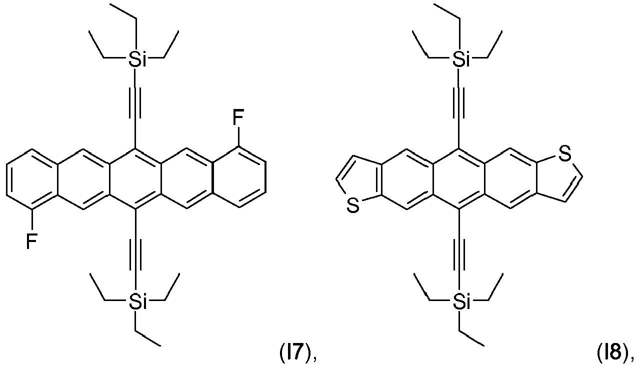

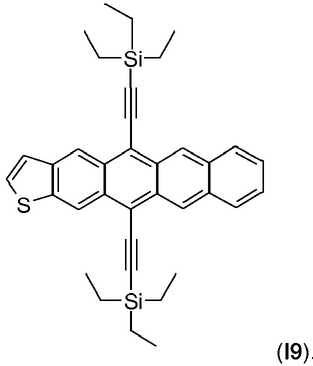

WO2008107089: 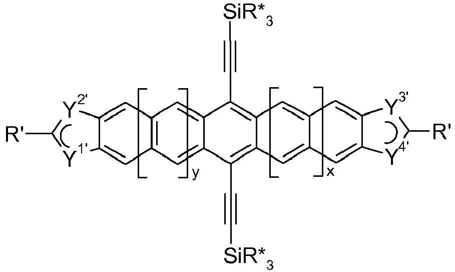 wherein one of Y^{1'} and Y^{2'} denotes -CH= or =CH- and the other denotes -X*-, one of Y^{3'} and Y^{4'} denotes -CH= or =CH- and the other denotes -X*-, X* is -O-, -S-, -Se- or -NR"'-, R* is cyclic, straight-chain or branched alkyl or alkoxy having 1 to 20 C-atoms, or aryl having 2-30 C-atoms, all of which are optionally fluorinated or perfluorinated, R' is H, F, Cl, Br, I, CN, straight-chain or branched alkyl or alkoxy having 1 to 20 C-atoms and optionally being fluorinated or perfluorinated, optionally fluorinated or perfluorinated aryl having 6 to 30 C-atoms, or CO₂R", with R" being H, optionally fluorinated alkyl having 1 to 20 C-atoms, or optionally fluorinated aryl having 2 to 30 C-atoms, R"' is H or cyclic, straight-chain or branched alkyl with 1 to 10 C-atoms, y is 0, or 1, x is 0, or 1.

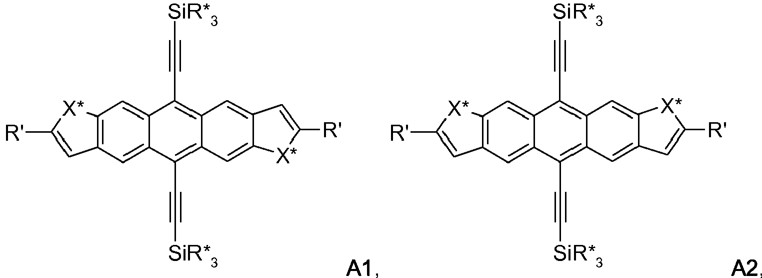

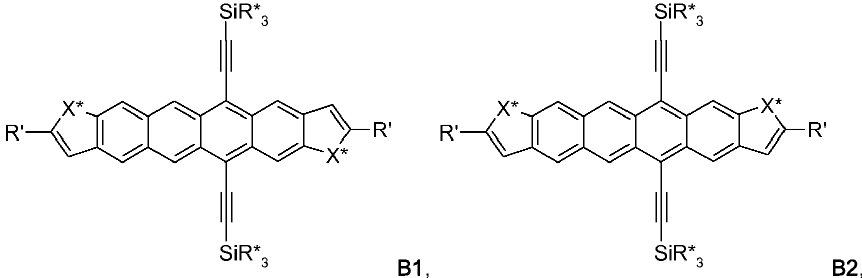

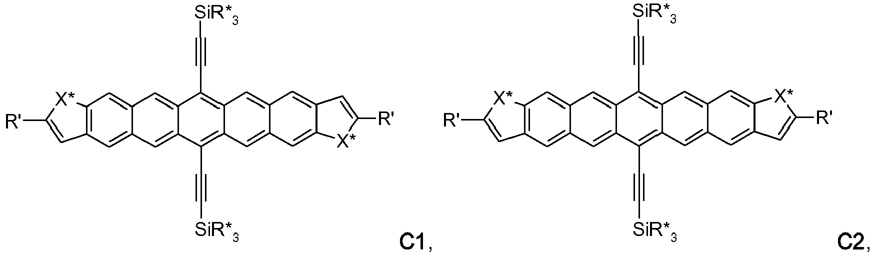

The polymer can contain a small molecule, or a mixture of two, or more small molecule compounds.

Accordingly, the present invention also relates to an organic semiconductor material, layer or component, comprising a polymer according to the present invention.

The polymers of the invention can be used as the semiconductor layer in semiconductor devices. Accordingly, the present invention also relates to semiconductor devices, comprising a polymer of the present invention, or an organic semiconductor material, layer or component. The semiconductor device is especially an organic photovoltaic (PV) device (solar cell), a photodiode, or an organic field effect transistor.

The polymers of the invention can be used alone or in combination as the organic semiconductor layer of the semiconductor device. The layer can be provided by any useful means, such as, for example, vapor deposition (for materials with relatively low molecular weight) and printing techniques. The compounds of the invention may be sufficiently soluble in organic solvents and can be solution deposited and patterned (for example, by spin coating, dip coating, ink jet printing, gravure printing, flexo printing, offset printing, screen printing, microcontact (wave)-printing, drop or zone casting, or other known techniques).

The polymers of the invention can be used in integrated circuits comprising a plurality of OTFTs, as well as in various electronic articles. Such articles include, for example, radiofrequency identification (RFID) tags, backplanes for flexible displays (for use in, for example, personal computers, cell phones, or handheld devices), smart cards, memory devices, sensors (e.g. light-, image-, bio-, chemo-, mechanical- or temperature sensors), especially photodiodes, or security devices and the like.

A further aspect of the present invention is an organic semiconductor material, layer or component comprising one or more polymers of the present invention. A further aspect is the use of the polymers or materials of the present invention in an organic photovoltaic (PV) device (solar cell), a photodiode, or an organic field effect transistor (OFET). A further aspect is an organic photovoltaic (PV) device (solar cell), a photodiode (photodetector) a sensor, a photoconductor, or an organic field effect transistor (OFET) comprising a polymer or material of the present invention.

The polymers of the present invention are typically used as organic semiconductors in form of thin organic layers or films, preferably less than 30 microns thick. Typically the semiconducting layer of the present invention is at most 1 micron (=1 µm) thick, although it may be thicker if required. For various electronic device applications, the thickness may also be less than about 1 micron thick. For example, for use in an OFET the layer thickness may typically be 100 nm or less. The exact thickness of the layer will depend, for example, upon the requirements of the electronic device in which the layer is used.

For example, the active semiconductor channel between the drain and source in an OFET may comprise a layer of the present invention.

An OFET device according to the present invention preferably comprises:
- a source electrode,
- a drain electrode,
- a gate electrode,
- a semiconducting layer,
- one or more gate insulator layers, and
- optionally a substrate, wherein the semiconductor layer comprises one or more polymers of the present invention.

The gate, source and drain electrodes and the insulating and semiconducting layer in the OFET device may be arranged in any sequence, provided that the source and drain electrode are separated from the gate electrode by the insulating layer, the gate electrode and the semiconductor layer both contact the insulating layer, and the source electrode and the drain electrode both contact the semiconducting layer.

Preferably the OFET comprises an insulator having a first side and a second side, a gate electrode located on the first side of the insulator, a layer comprising a polymer of the present invention located on the second side of the insulator, and a drain electrode and a source electrode located on the polymer layer.

The OFET device can be a top gate device or a bottom gate device.

Suitable structures and manufacturing methods of an OFET device are known to the person skilled in the art and are described in the literature, for example in WO03/052841.

The gate insulator layer may comprise for example a fluoropolymer, like e.g. the commercially available Cytop 809M®, or Cytop 107M® (from Asahi Glass). Preferably the gate insulator layer is deposited, e.g. by spin-coating, doctor blading, wire bar coating, spray or dip coating or other known methods, from a formulation comprising an insulator material and one or more solvents with one or more fluoro atoms (fluorosolvents), preferably a perfluorosolvent. A suitable perfluorosolvent is e.g. FC75® (available from Acros, catalogue number 12380). Other suitable fluoropolymers and fluorosolvents are known in prior art, like for example the perfluoropolymers Teflon AF® 1600 or 2400 (from DuPont), or Fluoropel® (from Cytonix) or the perfluorosolvent FC 43® (Acros, No. 12377).

The semiconducting layer comprising a polymer of the present invention may additionally comprise at least another material. The other material can be, but is not restricted to another polymer of the present invention, a semi-conducting polymer, a polymeric binder, organic small molecules different from a polymer of the present invention, carbon nanotubes, a fullerene derivative, inorganic particles (quantum dots, quantum rods, quantum tripods, TiO₂, ZnO etc.), conductive particles (Au, Ag etc.), and insulator materials like the ones described for the gate dielectric (PET, PS etc.). As stated above, the semiconductive layer can also be composed of a mixture of one or more polymers of the present invention and a polymeric binder. The ratio of the polymers of the present invention to the polymeric binder can vary from 5 to 95 percent. Preferably, the polymeric binder is a semicristalline polymer such as polystyrene (PS), high-density polyethylene (HDPE), polypropylene (PP) and polymethylmethacrylate (PMMA). With this technique, a degradation of the electrical performance can be avoided (cf. WO2008/001123A1).

The polymers of the present invention are advantageously used in organic photovoltaic (PV) devices (solar cells). Accordingly, the invention provides PV devices comprising a polymer according to the present invention. A device of this construction will also have rectifying properties so may also be termed a photodiode. Photoresponsive devices have application as solar cells which generate electricity from light and as photodetectors which measure or detect light.

The PV device comprise in this order:
(a) a cathode (electrode),
(b) optionally a transition layer, such as an alkali halogenide, especially lithium fluoride,
(c) a photoactive layer,
(d) optionally a smoothing layer,
(e) an anode (electrode),
(f) a substrate.

The photoactive layer comprises the polymers of the present invention. Preferably, the photoactive layer is made of a conjugated polymer of the present invention, as an electron donor and an acceptor material, like a fullerene, particularly a functionalized fullerene PCBM, as an electron acceptor. As stated above, the photoactive layer may also contain a polymeric binder. The ratio of the polymers of formula I to the polymeric binder can vary from 5 to 95 percent. Preferably, the polymeric binder is a semicristalline polymer such as polystyrene (PS), high-density polyethylene (HDPE), polypropylene (PP) and polymethylmethacrylate (PMMA).

For heterojunction solar cells the active layer comprises preferably a mixture of a polymer of the present invention and a fullerene, such as, for example, [60]PCBM (= 6,6-phenyl-C₆₁-butyric acid methyl ester), or [70]PCBM, in a weight ratio of 1:1 to 1:3. The fullerenes useful in this invention may have a broad range of sizes (number of carbon atoms per molecule). The term fullerene as used herein includes various cage-like molecules of pure carbon, including Buckminsterfullerene (C₆₀) and the related "spherical" fullerenes as well as carbon nanotubes. Fullerenes may be selected from those known in the art ranging from, for example, C₂₀-C₁₀₀₀. Preferably, the fullerene is selected from the range of C₆₀ to C₉₆. Most preferably the fullerene is C₆₀ or C₇₀, such as [60]PCBM, or [70]PCBM. It is also permissible to utilize chemically modified fullerenes, provided that the modified fullerene retains acceptor-type and electron mobility characteristics. The acceptor material can also be a material selected from the group consisting of any semi-conducting polymer, such as, for example, a polymer of the present invention, provided that the polymers retain acceptor-type and electron mobility characteristics, organic small molecules, carbon nanotubes, inorganic particles (quantum dots, quantum rods, quantum tripods, TiO₂, ZnO etc.).

The photoactive layer is made of a polymer of the present invention as an electron donor and a fullerene, particularly functionalized fullerene PCBM, as an electron acceptor. These two components are mixed with a solvent and applied as a solution onto the smoothing layer by, for example, the spin-coating method, the drop casting method, the Langmuir-Blodgett ("LB") method, the ink jet printing method and the dripping method. A squeegee or printing method could also be used to coat larger surfaces with such a photoactive layer. Instead of toluene, which is typical, a dispersion agent such as chlorobenzene is preferably used as a solvent. Among these methods, the vacuum deposition method, the spin-coating method, the ink jet printing method and the casting method are particularly preferred in view of ease of operation and cost.

In the case of forming the layer by using the spin-coating method, the casting method and ink jet printing method, the coating can be carried out using a solution and/or dispersion prepared by dissolving, or dispersing the composition in a concentration of from 0.01 to 90% by weight in an appropriate organic solvent such as benzene, toluene, xylene, tetrahydrofurane, methyltetrahydrofurane, N,N-dimethylformamide, acetone, acetonitrile, anisole, dichloromethane, dimethylsulfoxide, chlorobenzene, 1,2-dichlorobenzene and mixtures thereof.

The photovoltaic (PV) device can also consist of multiple junction solar cells (double, triple etc. junction organic photovoltaic device) that are processed on top of each other in order to absorb more of the solar spectrum. Such structures are, for example, described in App. Phys. Let. 90, 143512 (2007), Adv. Funct. Mater. 16, 1897-1903 (2006) and WO2004/112161.

A so called 'tandem solar cell' comprise in this order:
(a) a cathode (electrode),
(b) optionally a transition layer, such as an alkali halogenide, especially lithium fluoride,
(c) a photoactive layer,
(d) optionally a smoothing layer,
(e) a middle electrode (such as Au, Al, ZnO, TiO₂ etc.)
(f) optionally an extra electrode to match the energy level,
(g) optionally a transition layer, such as an alkali halogenide, especially lithium fluoride,
(h) a photoactive layer,
(i) optionally a smoothing layer,
(j) an anode (electrode),
(k) a substrate.

The PV device can also be processed on a fiber as described, for example, in US20070079867 and US 20060013549.

In certain embodiments, the electronic device can be configured as a photodiode. As known by those skilled in the art, photodiodes have a structure similar to that of solar cells, specifically, including a substrate, an anode, a cathode, and a photoactive layer between the anode and the cathode that can incorporate one or more polymers of the present invention.

Due to their excellent self-organising properties the materials or films comprising the polymers of the present invention can also be used alone or together with other materials in or as alignment layers in LCD or OLED devices, as described for example in US2003/0021913.

The following examples are included for illustrative purposes only and do not limit the scope of the claims. Unless otherwise stated, all parts and percentages are by weight.

Weight-average molecular weight (Mw) and polydispersity (Mw/Mn = PD) are determined by High Temperature Gel Permeation Chromatography (HT-GPC) [Apparatus: GPC PL 220 from Agilent Technologies (Santa Clara, CA, USA) yielding the responses from refractive index (RI), Chromatographic conditions: Column: 3 "PLgel Mixed B" columns from Agilent Technologies (Santa Clara, CA, USA); with an average particle size of 10□µm (dimensions 300 x 7.5 mm I.D.) Mobile phase: 1,2,4-trichlorobenzene (for GPC, AppliChem, Darmstadt, Germany) stabilised by butylhydroxytoluene (BHT, 1 g/I), Chromatographic temperature: 150°C; Mobile phase flow: 1 ml/min; Solute concentration: about 1 mg/ml; Injection volume: 200 µl; Detection: RI, Procedure of molecular weight calibration: Relative calibration is done by use of a EasiVial calibration kit from Agilent Technologies (Santa Clara, CA, USA) containing 12 narrow polystyrene calibration standards spanning the molecular weight range from 6'035'000 Da - 162 Da, i. e., PS 6'035'000, PS 3'053'000, PS 915'000, PS 483'000, PS 184'900, PS 60'450, PS 19'720, PS 8'450, PS 3'370, PS 1'260, PS 580, PS 162 Da. A polynomic calibration is used to calculate the molecular weight.

All polymer structures given in the examples below are idealized representations of the polymer products obtained via the polymerization procedures described. If more than two components are copolymerized with each other sequences in the polymers can be either alternating or random depending on the polymerisation conditions.

### Examples

### Example 1: Synthesis of polymer P-1

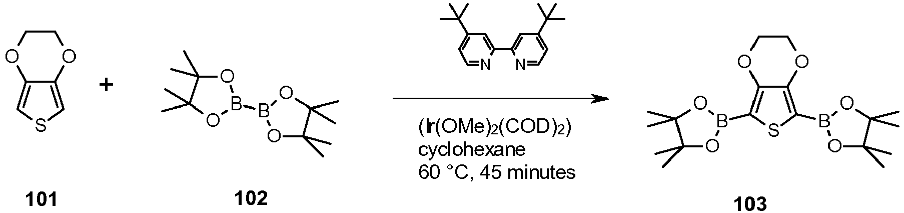

a) The synthesis of compound 101 is described, for example, in WO2009115413. To a previously prepared solution of 3,4-ethylenedioxythiophene 101 (2.00 g, 14.07 mmol), 4,4'-di-tert-butyl-2,2'-dipyridyl (132 mg, 0.49 mmol) and (1,5-cyclooctadiene)(methoxy)-iridium (I) dimer (163 mg, 0.25 mmol) in cyclohexane (30 mL) placed under an argon atmosphere is added at 60 °C over 30 minutes a solution of bis(pinacolato)diboron 102 (3.93 g, 15.47 mmol) in cyclohexane (30 mL). The resulting mixture is then stirred at 60 °C for 15 additional minutes. After that time the reaction mixture is cooled down, and the product crystallizes. The white crystals are filtered, washed with cyclohexane and dried at 60 °C under reduced pressure (yield: 66% (3.66 g, white crystals)). ¹H NMR (400 MHz, CDCl₃): *δ* = 7.75 (s, 1H), 7.47-7.22 (m, 10H), 6.86 (s, 1H), 5.81 (d, *J* = 7.0 Hz, 1 H), 4.96 (d, J = 7.2 Hz, 1 H), 0.46 (s, 9H), 0.30 (s, 9H). ¹³C NMR (100 MHz, CDCl₃): *δ* = 152.3, 142.4, 141.9, 141.3, 140.5, 138.7, 135.6, 131.1, 128.9 (2C), 128.7 (2C), 128.2 (2C), 128.1 (2C), 127.5, 127.2, 125.8 (2C), 125.2, 116.2, 94.1, 58.4, -0.2 (3C), -0.4 (3C). GC/MS: (Cl pos.): 529.28 (MH⁺). 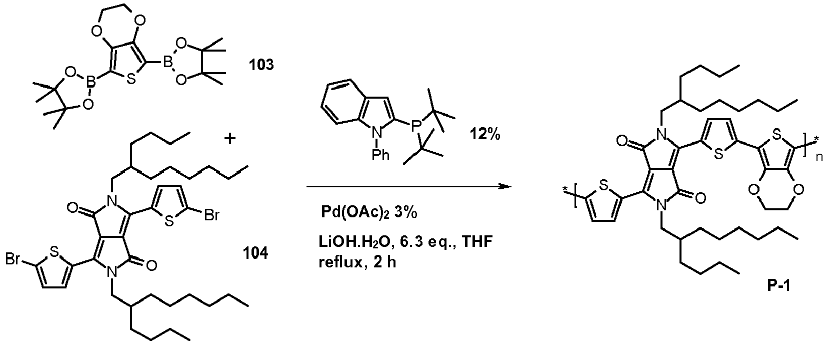
b) The synthesis of 3,6-bis(5-bromothiophen-2-yl)-2,5-bis(2-butyloctyl)pyrrolo[3,4-c]pyrrole-1,4(2H,5H)-dione 104 is, for example, described in O.P. Lee et al., Adv. Mater. 23 (2011) 5359-5363. In a flask equiped with a condenser, a mechanical stirrer and a thermometer is introduced bis-boronic ester 103 from step a) (600 mg, 1.52 mmol) and 3,6-bis(5-bromothiophen-2-yl)-2,5-bis(2-butyloctyl)pyrrolo[3,4-c]pyrrole-1,4(2H,5H)-dione 104 (1.152 g, 1.45 mmol). The flask is flushed with argon and dry THF (50 mL) is added by syringe. The resulting solution is heated to reflux temperature and a solution of palladium(II) acetate (9.8 mg, 0.043 mmol) and 2-(di-tert-butylphosphino)-1-phenylindole (58.7 mg, 0.174 mmol) in 5 mL THF is added at 50 °C. The resulting mixture is stirred for 5 minutes at 60 °C. After that time finely crushed lithium hydroxide monohydrate (383 mg, 9.14 mmol) is added in a single portion and the mixture is stirred at reflux temperature for 2 hours. The reaction mixture is then cooled to room temperature and poured into water (75 mL) and the precipitate is filtered on a Büchner funnel. The solid is then washed with water. The filtered solid is then put in a flask containing 140 mL o-dichlorobenzene and 7 g of sodiumdiethyldithiocarbamate dissolved in 140 mL of water. The mixture and is heated under vigourous stirring at 95 °C overnight. The phases are separated, and the organic phase is washed with 3 x 100 mL water. Ethanol is added to precipitate the product, which is filtered on a Büchner funnel, and dried under reduced pressure at 60 °C. The dried solid is then purified by soxhlet extraction, first with cyclohexane (160 mL, 2 h) and tetrahydrofuran (THF, 160 mL, 2 h). The fractions soluble in cyclohexane and tetrahydrofuran are discarded and the remaining solid is then subjected to soxhlet extraction with chloroform (160 mL, 4 h). The green solution is concentrated, the product is precipitated in ethanol, filtered and dried under reduced pressure to afford the polymer P-1 (820 mg, yield 73%). High temperature GPC: Mw = 4075, PDI = 1.22.

### Example 2: Synthesis of polymer P-2

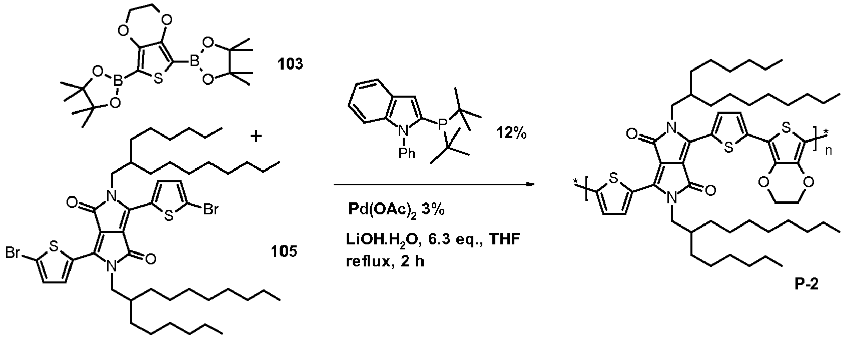

The synthesis of 3,6-bis(5-bromothiophen-2-yl)-2,5-bis(2-hexyldecyl)pyrrolo[3,4-c]pyrrole-1,4(2H,5H)-dione 105 is, for example, described in WO2008/000664 and Y. Geerts; Tetrahedron 66 (2010) 1837-1845. In a flask equiped with a condenser, a mechanical stirrer and a thermometer is introduced bis-boronic ester 103 (501 mg, 1.27 mmol) and 3,6-bis(5-bromothiophen-2-yl)-2,5-bis(2-hexyldecyl)pyrrolo[3,4-c]pyrrole-1,4(2H,5H)-dione 105 (1.100 g, 1.21 mmol). The flask is flushed with argon and dry THF (30 mL) is added by syringe. The resulting solution is heated to reflux temperature and a solution of palladium(II) acetate (8.2 mg, 0.036 mmol) and 2-(di-tert-butylphosphino)-1-phenylindole (49.1 mg, 0.146 mmol) in 5 mL THF is added at 55 °C. The resulting mixture is stirred for 5 minutes at 60 °C. After that time finely crushed lithium hydroxide monohydrate (320 mg, 7.64 mmol) is added in a single portion and the mixture is stirred at reflux temperature for 2 hours. The reaction mixture is then cooled to room temperature and poured into water (75 mL) and the precipitate is filtered on a Büchner funnel. The solid is then washed with water. The filtered solid is then put in a flask containing 100 mL of chloroform and 100 mL of a 2% NaCN aqueous solution. The mixture and is heated under vigourous stirring at 55 °C overnight. The phases are separated and the organic phase is washed with 3 x 800 mL water. Ethanol is added to precipitate the product, which is filtered on a Büchner funnel, and dried under reduced pressure at 60 °C. The dried solid is then purified by soxhlet extraction, first with acetone (160 mL, 3 h) and cyclohexane (160 mL, 2 h), and finally in tetrahydrofuran (THF) (160 mL, 1.5 h). The fraction soluble in THF are concentrated, the product is precipitated in ethanol, filtered and dried under reduced pressure to afford the polymer P-2 (Cyclohexane fraction, 660 mg, yield 62% and THF fraction, 280 mg, yield 26%). High temperature GPC: THF fraction: Mw = 4800, PDI = 1.22, cyclohexane fraction: Mw = 4700, PDI = 1.26.

### Application Examples 1-3: Solar Cells:

**The solar cell/photodiode device has the following structure:** Al electrode/LiF layer/organic layer, comprising a polymer of the present invention and [70]PCBM /[poly(3,4-ethylenedioxy-thiophene) (PEDOT) in admixture with poly(styrenesulfonic acid) (PSS)]/ITO electrode/glass substrate. The solar cells are made by spin coating a layer of the PEDOT-PSS on a pre-patterned ITO on glass substrate. Then a 1:2 mixture of a polymer of the present invention(0.8% by weight) : [70]PCBM (a substituted C₇₀ fullerene) is spin coated from solvent mixture (organic layer). LiF and Al are sublimed under high vacuum through a shadow-mask.

### Solar cell performance:

The solar cell is measured under Aescusoft solar light simulator with halogen light source. Then with the External Quantum Efficiency (EQE) graph the current is estimated under AM 1.5 conditions.

Results of OPV measurements are reported in the Table 1:

| **Example** | **Semiconductor** | **Solvent Mixture** | **Jsc, mA/cm2** | **Voc, V** | **FF, %** | **η,%** |
|---|---|---|---|---|---|---|
| 1 | **P-1** | CHCl₃/o-dichlorobenzene (8:2) | -21.31 | 0.36 | 34.8 | 2.74 |
| 2 | **P-1** | 3-Methylthiophene / 1-Mehyl-naphthalene (8:2) | -6.84 | 0.31 | 40.6 | 0.89 |
| 3 | **P-2** (cyclohex. fract.) | CHCl₃/o-dichlorobenzene (8:2) | -6.01 | 0.40 | 58.5 | 1.44 |

External Quantum Efficiency (EQE) measurements are carried out using Aescusoft Gimo dual grating monochromator system under one sun bias obtained through a halogen lamp. Polymers **P-1** and **P-2** show onset of photoresponse around 1200 nm (1.03 eV), which allows to use these polymers for detection in IR area.

## Claims

1. A polymer, comprising repeating units of the formula 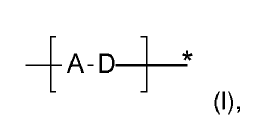 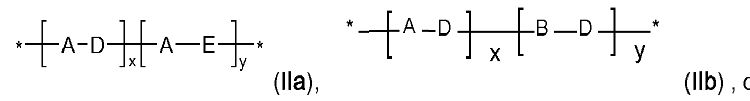 or 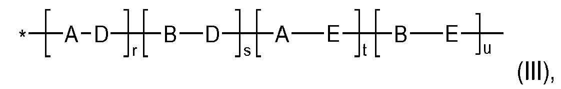 wherein x = 0.01 to 0.99, y = 0.99 to 0.01, and wherein x + y = 1,
r + s = 0.01 to 0.99, t + u = 0.99 to 0.01, and wherein r + s + t + u = 1,
A is a group of formula 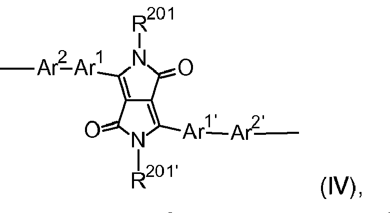 Ar¹, Ar^{1'}, Ar² and Ar^{2'} are independently of each other a group of formula 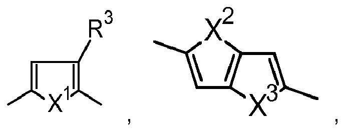 X¹ is O, S, or Se, especially S;
X² and X³ are independently of each other O, S, or Se, especially S;
R³ is H, C₁-C₂₅alkyl, C₃-C₁₂cycloalkyl, C₁-C₂₅alkoxy or C₁-C₂₅thioalkyl, C₂-C₂₅alkenyl, or C₂-C₂₅alkynyl,
R²⁰¹ and R^{201'} are independently of each other H, C₁-C₁₀₀alkyl, C₂-C₁₀₀alkenyl, or C₂-C₁₀₀alkynyl, -COOR¹⁰³, C₁-C₁₀₀alkyl which is substituted by one or more halogen atoms, hydroxyl groups, nitro groups, -CN, or C₆-C₁₈aryl groups and/or interrupted by -O-, -COO-, -OCO- or -S-; C₇-C₂₅arylalkyl, carbamoyl, C₅-C₁₂cycloalkyl, which can be substituted one to three times with C₁-C₁₀₀alkyl and/or C₁-C₁₀₀alkoxy; C₆-C₂₄aryl, in particular phenyl or 1- or 2 naphthyl which can be substituted one to three times with C₁-C₁₀₀alkyl, C₁-C₁₀₀thioalkoxy, and/or C₁-C₁₀₀alkoxy; and pentafluorophenyl;
R¹⁰³ is C₁-C₂₅alkyl, which may optionally be interrupted by one, or more oxygen, or sulphur atoms;
D is a group of formula 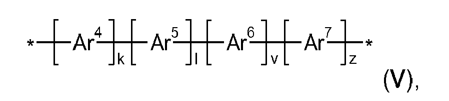 k is 0, or 1,
l is 1,
v is 0, or 1,
z is 0, or 1,
Ar⁴, Ar⁵, Ar⁶ and Ar⁷ are independently of each other a group of formula 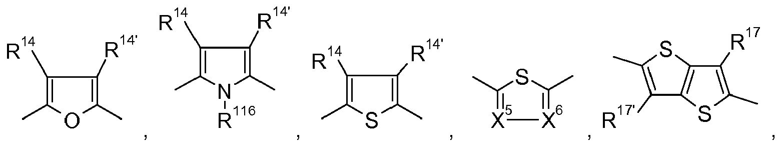 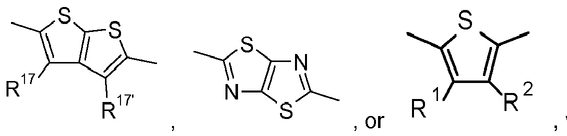 wherein one of X⁵ and X⁶ is N and the other is CR¹⁴,
R¹⁴, R^{14'}, R¹⁷ and R^{17'} are independently of each other H, or a C₁-C₂₅alkyl group, which may optionally be interrupted by one or more oxygen atoms;
R¹¹⁶ is C₆-C₁₈aryl; C₆-C₁₈aryl which is substituted by C₁-C₁₈alkyl, or C₁-C₁₈alkoxy; or C₁-C₂₅alkyl, which may optionally be interrupted by one or more oxygen or sulphur atoms; or C₇-C₂₅arylalkyl;
R¹ and R² are independently of each other C₁-C₂₅alkoxy, or C₁-C₂₅thioalkyl; or
R¹ and R² form together a group 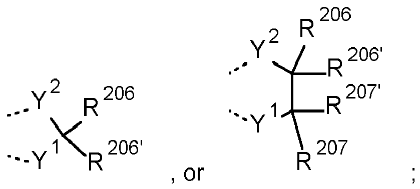 Y¹ and Y² are independently of each other O, or S;
R²⁰⁶, R^{206'}, R²⁰⁷ and R^{207'} are independently of each other H, C₁-C₁₈alkyl, C₁-C₁₈alkyl which is interrupted one, or more times by O; C₁-C₁₈alkoxy, C₁-C₁₈alkoxy which is interrupted one, or more times by O; C₁-C₁₈fluoroalkyl, C₂-C₁₈alkenyl, C₂-C₁₈alkynyl, or CN; with the proviso that at least one of Ar⁴, Ar⁵, Ar⁶ and Ar⁷ is a group of
formula 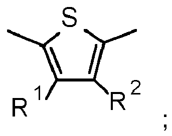 B is a group of formula IV, which is different from A, or B is a group of formula V, which is different from D;
E is a group of formula V, which is different from D, or E is a group of formula IV, which is different from A.

2. The polymer according to claim 1, comprising repeating units of the formula 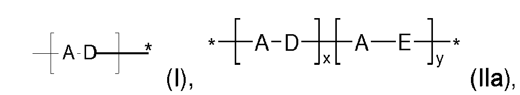 or 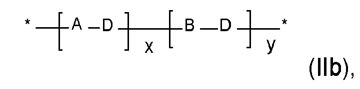 wherein
x = 0.01 to 0.99, y = 0.99 to 0.01, and wherein x + y = 1,
A is a group of formula 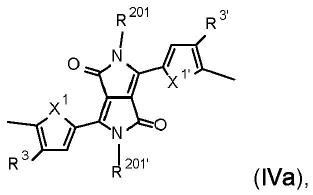 X¹ and X^{1'} are independently of each other O, S, or Se, especially S;
R³ and R^{3'} are independently of each other H, C₁-C₂₅alkyl, C₃-C₁₂cycloalkyl, C₁-C₂₅alkoxy, C₁-C₂₅thioalkyl, C₂-C₂₅alkenyl, or C₂-C₂₅alkynyl,
R²⁰¹ and R^{201'} are independently of each other H, C₁-C₁₀₀alkyl, C₂-C₁₀₀alkenyl, or C₂-C₁₀₀alkynyl, or C₁-C₁₀₀alkyl which is interrupted by -O-;
D is a group of formula 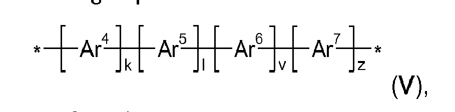 k is 0, or 1,
l is 1,
v is 0, or 1,
z is 0, or 1,
Ar⁴, Ar⁵, Ar⁶ and Ar⁷ are independently of each other a group of formula 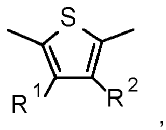 wherein R¹ and R² are C₁-C₂₅alkoxy, or C₁-C₂₅thioalkyl; or
R¹ and R² form together a group 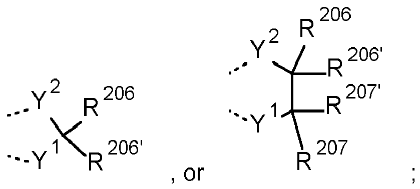 Y¹ and Y² are independently of each other O, or S;
R²⁰⁶, R^{206'}, R²⁰⁷ and R^{207'} are independently of each other H, C₁-C₁₈alkyl, or C₁-C₁₈alkyl which is interrupted one, or more times by O.
E is a group of formula V, which is different from D, and
B is a group of formula V, which is different from D.

3. The polymer according to claim 2, wherein
A is a group of formula 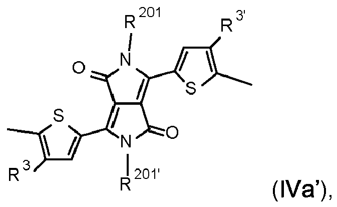 or 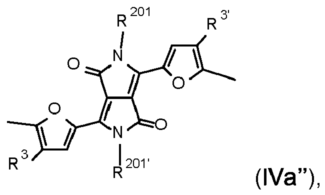 R³ and R^{3'} are independently of each other H, C₁-C₂₅alkoxy, C₁-C₂₅thioalkyl, or C₁-C₂₅alkyl, and
R²⁰¹ and R^{201'} are independently of each other C₁-C₁₀₀alkyl.

4. The polymer according to claim 1, comprising repeating units of the formula 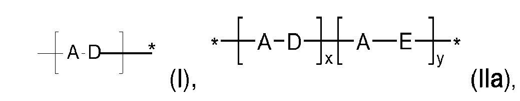 or 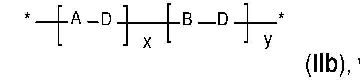 wherein
A is a group of formula 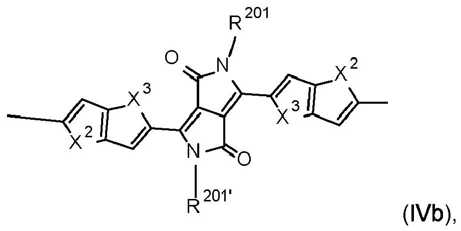 X² and X³ are independently of each other O, S, or Se, especially S;
R²⁰¹ and R^{201'} are independently of each other H, C₁-C₁₀₀alkyl, C₂-C₁₀₀alkenyl, or C₂-C₁₀₀alkynyl, C₁-C₁₀₀alkyl which is interrupted by-O-; and
x, y, B, D and E are as defined in claim 2.

5. The polymer according to claim 4, wherein
A is a group of formula 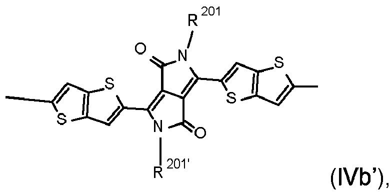 wherein R²⁰¹ and R^{201'} are independently of each other C₁-C₁₀₀alkyl.

6. The polymer according to any of claims 1 to 5, wherein D is a group of formula 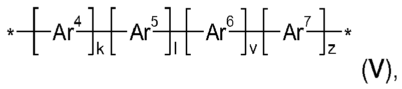 k is 0, or 1,
l is 1,
v is 0, or 1,
z is 0, or 1,
Ar⁴, Ar⁵, Ar⁶ and Ar⁷ are independently of each other a group of formula 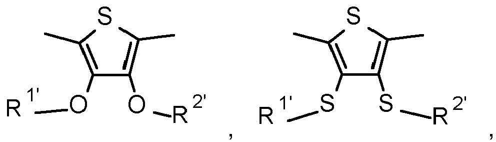 especially 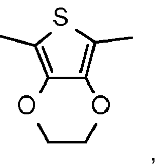 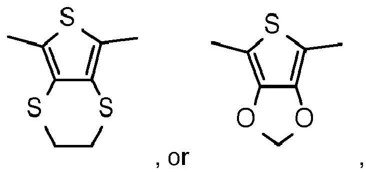 wherein R^{1'} and R^{2'} are C₁-C₂₅alkyl, and B and E are as defined in claim 2.

7. The polymer according to claim 6, wherein D is a group of formula 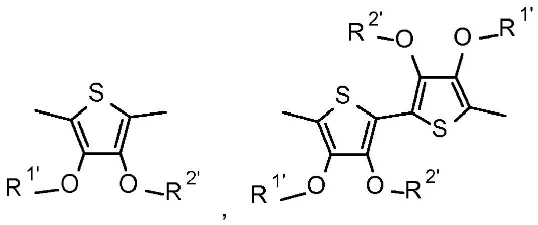 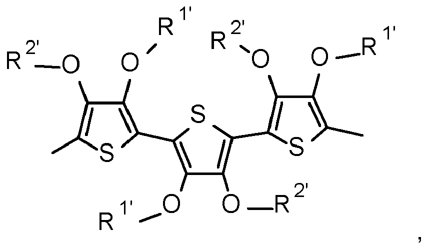 especially 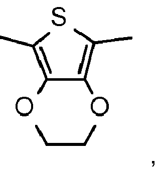 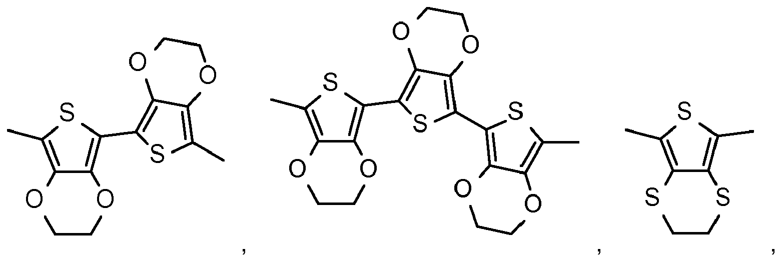 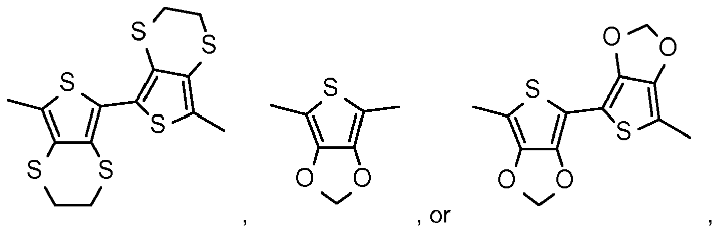 wherein R^{1'} and R^{2'} are C₁-C₂₅alkyl.

8. The polymer according to any of claims 1 to 7, which is a polymer of formula: 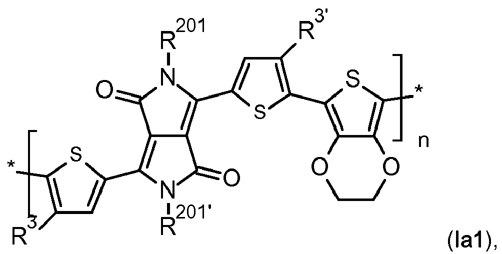 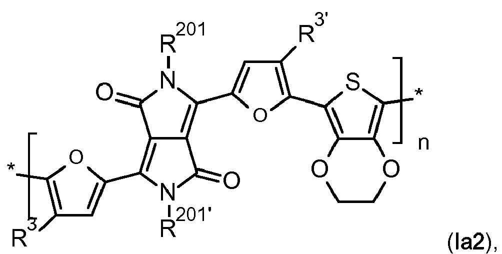 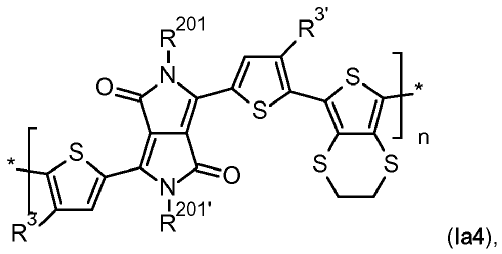 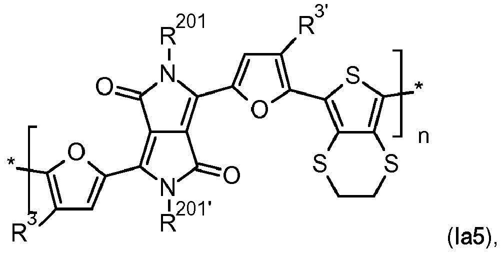 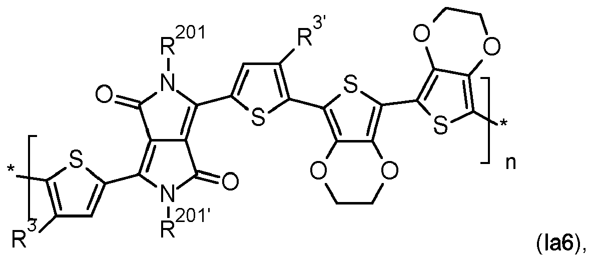 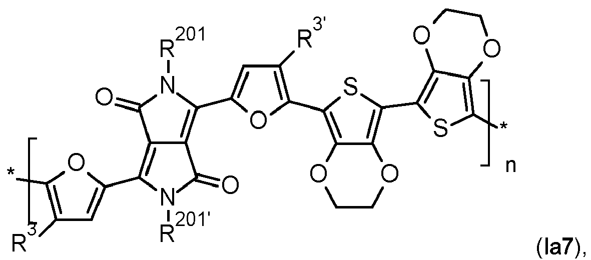 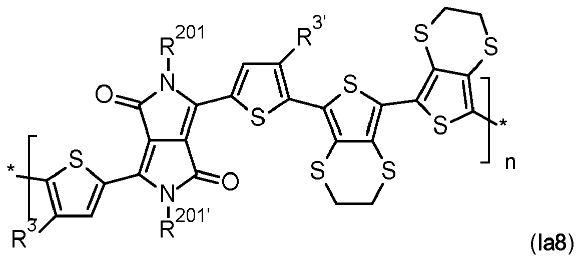 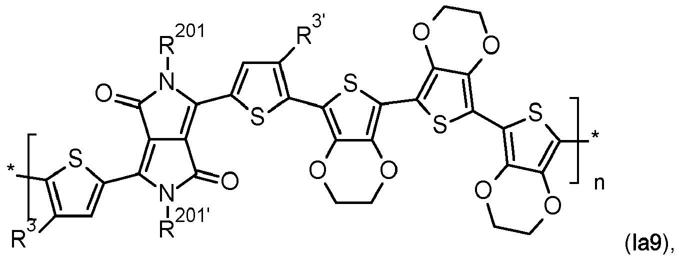 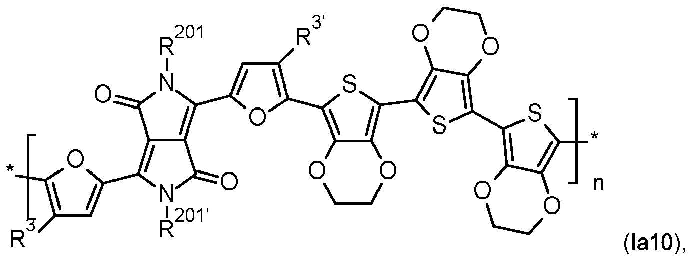 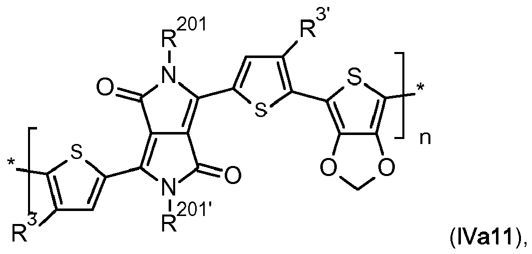 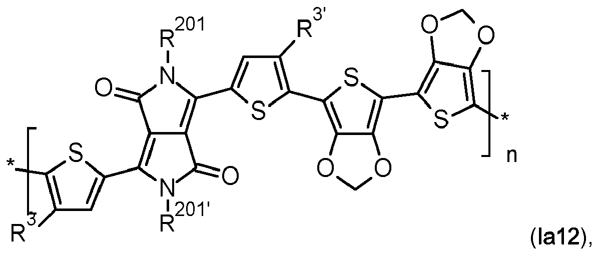 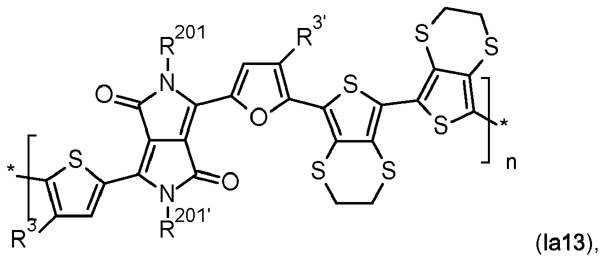 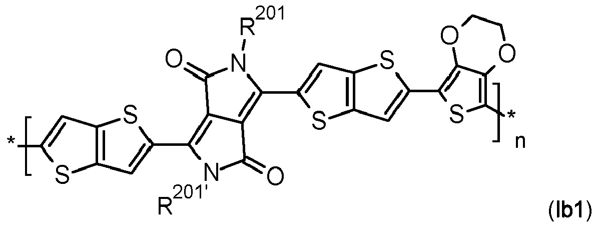 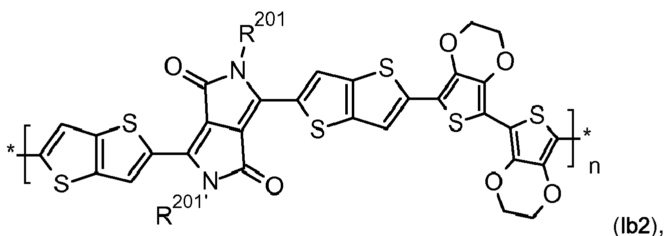 wherein n is 4 to 1000, especially 4 to 200, very especially 5 to 150;
R³ and R^{3'} are independently of each other hydrogen or C₁-C₂₅alkyl; R²⁰¹ and R^{201'} are independently of each other C₁-C₁₀₀alkyl.

9. The polymer according to claim 8, which is a polymer of formula: 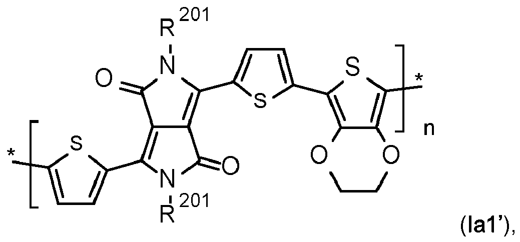 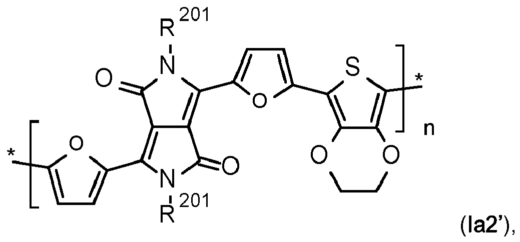 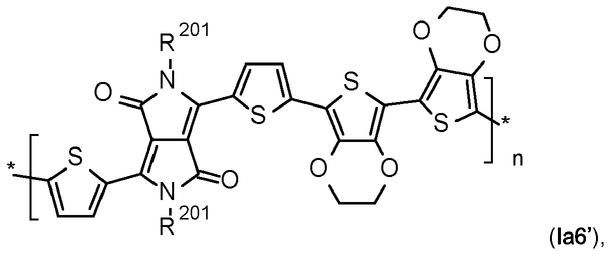 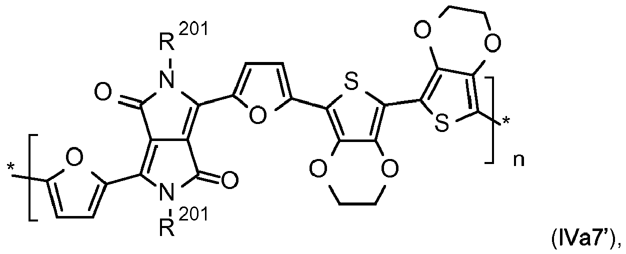 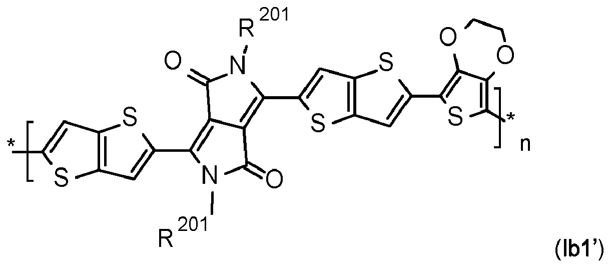 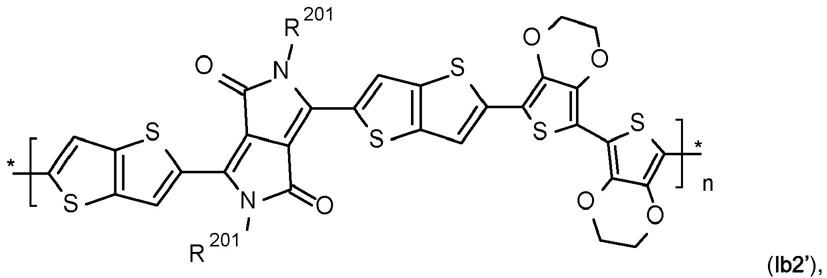 wherein
n is 4 to 1000, especially 4 to 200, very especially 5 to 150;
R²⁰¹ is C₁-C₁₀₀alkyl.

10. An organic semiconductor material, layer or component, comprising a polymer according to any of claims 1 to 9.

11. An electronic device, comprising a polymer according to any of claims 1 to 9 and/or an organic semiconductor material, layer or component according to claim 10.

12. The electronic device according to claim 11, which is an organic light emitting diode, an organic photovoltaic device, a photodiode, a sensor, photoconductor, or an organic field effect transistor.

13. Process for the preparation of an electronic device, which process comprises applying a solution and/or dispersion of a polymer according to any of claims 1 to 9 in an organic solvent to a suitable substrate and removing the solvent.

14. Use of the polymer according to any of claims 1 to 9, and/or the organic semiconductor material, layer or component according to claim 10 in organic light emitting diodes, photovoltaic devices, photodiodes, sensors, photoconductors, or organic field effect transistors.
